# EUROPEAN PATENT SPECIFICATION

(11) **EP 1 998 387 B1**
(45) Date of publication and mention of the grant of the patent: **22.04.2015**
(21) Application number: 07738388.3
(22) Date of filing: 13.03.2007
(51) Int. Cl.: H01L 51/50, H01L 51/54, C09K 11/06

(54) **ORGANIC ELECTROLUMINESCENT DEVICE, DISPLAY AND ILLUMINATING DEVICE**
ORGANISCHE ELEKTROLUMINESZENZVORRICHTUNG, ANZEIGE UND BELEUCHTUNGSVORRICHTUNG
DISPOSITIF ELECTROLUMINESCENT ORGANIQUE, DISPOSITIF D'ECLAIRAGE ET D'AFFICHAGE

(30) Priority: 17.03.2006 JP 2006074177; 18.05.2006 JP 2006138706
(43) Date of publication of application: 03.12.2008
(73) Proprietor: KONICA MINOLTA HOLDINGS, INC., Tokyo 100-0005 (JP)
(72) Inventor: YASUKAWA, Noriko, Hino-shi Tokyo 191-8511 (JP); KATOH, Eisaku, Hino-shi Tokyo 191-8511 (JP); OTSU, Shinya, iHino-shi Tokyo 191-8511 (JP); SUZURI, Yoshiyuki, Hino-shi Tokyo 191-8511 (JP); SUGITA, Shuichi, Hino-shi Tokyo 191-8511 (JP); KITA, Hiroshi, Hino-shi Tokyo 191-8511 (JP); NAKATA, Aki, Hino-shi Tokyo 191-8511 (JP)
(74) Representative: Gille Hrabal
(86) International application number: PCT/JP2007/054916
(87) International publication number: WO 2007/108362

(56) References cited:
- EP-A1- 1 571 193
- EP-A1- 1 953 843
- WO-A1-2005/123873
- WO-A1-2006/009024
- JP-A- 2003 109 758
- JP-A- 2006 028 101
- JP-A- 2006 032 599
- US-A1- 2005 260 448
- US-A1- 2006 008 670
- NAM, E.J., KIM, J.H., KIM, B.-O., KIM, S.M., PARK, N.G., KIM, Y.S., KIM, Y.K., HA, Y.: "A Synthesis and Luminescence Study of Ir(ppz)3 for Organic Light-Emitting Devices", BULL. CHEM. SOC. JPN., vol. 77, 2 April 2004 (2004-04-02), pages 751-755, XP002628525,
- KANNO, H., HOLMES, R.J., SUN, Y, KENA-COHEN, S., FORREST, S.R.: "White stacked electrophosphorescent organic light emitting devices employing MoO3 as a charge-generation layer", ADV. MATER., vol. 18, 10 January 2006 (2006-01-10), pages 339-342, XP002628526,

## Description

### TECHNICAL FIELD

The present invention relates to an organic electroluminescent element, a display device and a lighting device.

### BACKGROUND OF ART

Conventionally, an emission type electronic display device includes an electroluminescence display (hereinafter, referred to as an ELD). A constituent element of ELD includes such as an inorganic electroluminescent element and an organic electroluminescent element (hereinafter, referred to as an organic EL element). An inorganic electroluminescent element has been utilized as a flat light source, however, requires a high voltage of alternating current to operate an emission element.

On the other hand, an organic electroluminescent element is an element provided with a constitution comprising an emission layer containing a emitting substance being sandwiched with a cathode and an anode, and an exciton is generated by an electron and a positive hole being injected into the emission layer to be recombined, resulting emission utilizing light release (fluorescence-phosphorescence) at the time of deactivation of said exciton; the emission is possible at a voltage of approximately a few to a few tens volts, and an organic electroluminescent element is attracting attention with respect to such as superior viewing angle and high visual recognition due to a self-emission type as well as space saving and portability due to a completely solid element of a thin layer type.

In an organic electroluminescence in view of the future practical application, desired has been development of an organic EL element which efficiently emits at a high luminance with a low electric consumption. Examples of such technologies are a slight amount of a fluorescent substance doped in a stilbene derivative, distyrylarylene derivative or a tristyrylarylene derivative, to achieve improved emission luminance and a prolonged lifetime of an element (for example, refer to Patent Document No. 4). Further, there are known such as an element having an organic emission layer comprising a 8-hydroxyquinoline aluminum complex as a host compound which is doped with a slight amount of a fluorescent substance (for example, refer to Patent Document No. 5). and an element having an organic emission layer comprising a 8-hydroxyquinoline aluminum complex as a host compound which is doped with quinacridone type dye (for example, refer to Patent Document No. 6).

Regarding to the technologies disclosed in the above-described Patent Documents, when emission from an excited singlet is utilized, since a generation ratio of a singlet exciton to a triplet exciton is 1/3, that is, a generation probability of an emitting exciton species is 25% and a light taking out efficiency is approximately 20%, the limit of a quantum efficiency (ηext) of taking out is said to be 5%.

However, since an organic EL element which utilizes phosphorescence from an excited triplet has been reported from Princeton University (for example, refer to Non Patent Document 3), researches on materials exhibiting phosphorescence at room temperature have come to be active. Since the upper limit of internal quantum efficiency becomes 100% by utilization of an excited triplet, which is principally 4 times of the case of an excited singlet, it may be possible to achieve almost the same ability as a cooled cathode ray tube to attract attention also for an illumination application.

As a dopant used for an organic electroluminescent element employing phosphorescence, many compounds mainly belonging to iridium complexes have been investigated (for example, refer to Non Patent Document No. 5). An example is tris(2-phenylpyridine)iridium (refer to Non Patent Document No. 4). In addition to that, there have been studied to use L₂Ir (acac) such as (ppy)₂Ir(acac) as a dopant (for example, refer to Non Patent Document No. 6). Also there have been studied to use compounds such as tris(2-(p-tolyl)pyridine)iridium (Ir(ptpy)₃) and tris(benzo [h] quinoline) iridium (Ir (bzq) ₃) / Ir (bzq) ₂CIP (Bu) ₃ (for example, refer to Non Patent Document No. 3). Also known are investigations on iridium complexes having phenyl pyrazole as a ligand (refer to Non Patent Documents No. 1 and No. 3) or phenyl imidazole as a ligand (refer to Patent Document 7).

Firstly, the Fir(pic), which is a typical phosphorescent blue dopant, has achieved a shortening of emission wavelength with a fluorine-substituted phenylpyridine and a picolinic acid being employed as a major ligand and an auxiliary ligand respectively. Further, an introduction of a pirazole type ligand, as an auxiliary ligand other than the picolinic acid, has been known to shorten an emission wavelength (for example, refer to Patent Document 1 and Non-Patent Documents 1 and 2). The aforesaid dopants, in combination with carbazol derivatives or triarylsilanes as a host compound, have realized highly efficient elements, but on the other hand, have significantly degraded emission life of the elements. Then, improvement to overcome the trade-off relationship has been demanded.

Any of the above-described blue dopants are such types of compounds that the dopant materials have a low level of the highest occupied molecular orbital (hereinafter abbreviated as "HOMO") and the lowest unoccupied molecular orbital (hereinafter abbreviated as "LUMO"). The HOMO and LUMO levels of the above dopants are lower by about 1 eV when compared to those of an Ir(ppy)₃, which is a typical phosphorescent green dopant. As a blue dopant, compounds having low HOMO and LUMO levels have been known, but only a few compounds having high HOMO and LUMO levels are reported. Recently, blue dopants having high HOMO-LUMO levels were reported (for example, refer to Patent Documents 2 and 3), but reported were only examples in which the aforesaid dopants were combined with heretofore known host compounds having high HOMO and LUMO levels. The emission life of the above elements has never been satisfactory, and improvement thereof has been desired.

Secondly, as one of the shortcomings of the organic EL element employing the above-described phosphorescent light-emitting dopant, listed is the short emission life during continuous driving. Extending the emission life has been studied, but the lifetime has been unsatisfactory.
Patent Document 1: WO 02/15645
Patent Document 2: U.S. Patent Application Publication No. 2004/0048101
Patent Document 3: WO 04/085450
Patent Document 4: Japanese Patent Registration No. 3093796
Patent Document 5: Unexamined Japanese Patent Application Publication (hereinafter referred to as JP-A) No. 63-264692
Patent Document 6: JP-A No. 3-255190
Patent Document 7: US 2006/008670 A
Non-Patent Document 1: C. Adachi et al., Applied Physics Letters, Vol. 79, No. 13, pages 2082 - 2084 (2003)
Non-Patent Document 2: J. Holmes et al., Applied Physics Letters, Vol. 83, No. 18, pages 3818 - 3820 (2003)
Non-Patent Document 3: M. A. Baldo et al., Nature, Vol. 395, pages 151 - 154 (1998)
Non-Patent Document 4: M. A. Baldo et al., Nature, Vol. 403, No. 17, pages 750 - 753 (2000)
Non-Patent Document 5: S. Lamansky et al., J. Am. Chem. Soc., Vol. 123, page 4304 (2001)
Non-Patent Document 6: M. E. Tompson et al., The 10th International Workshop on Inorganic and Organic Electroluminescence (EL' 00, Hamamatsu)
Non-Patent Document 7: Moon-Jae Youn. Og, Tetsuo Tsutsui et al., The 10th International Workshop on Inorganic and Organic Electroluminescence (EL' 00, Hamamatsu)

### DISCLOSURE OF THE INVENTION

### PROBLEMS TO BE SOLVED BY THE INVENTION

Thus, the object of the present invention is to provide a blue phosphorescent light-emitting organic electroluminescent element which can be driven at a low voltage, and a display device and a lighting device both of which employ the aforesaid element.

### MEANS TO SOLVE THE PROBLEMS

The object of the present invention described above has been achieved by claims 1-7.

### EFFECTS OF THE INVENTION

According to claims 1-7, a blue phosphorescent light-emitting organic electroluminescent element which can be driven at a low voltage, and a display device and a lighting device both of which employ the aforesaid element, were provided.

### BRIEF DESCRIPTION OF THE DRAWINGS

Fig. 1 is a schematic drawing to show a basic layer structure of the present invention.
Fig. 2 is a schematic drawing to show an example of a display device constituted of an organic EL element.
Fig. 3 is a schematic drawing of display section A.
Fig. 4 is an equivalent circuit diagram of an image pixel.
Fig. 5 is a schematic drawing of a full color display device according to a passive matrix mode.

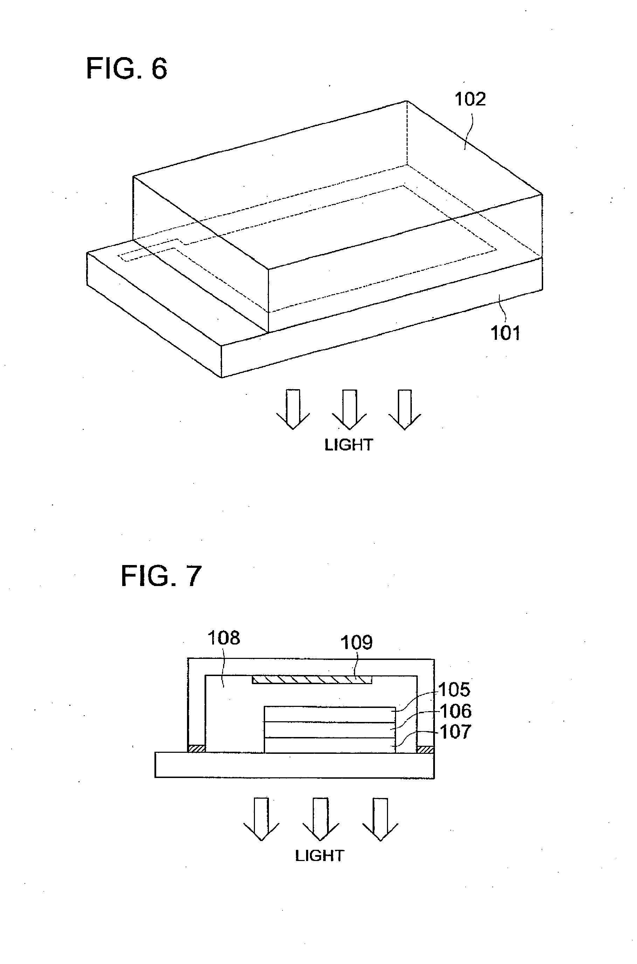

Fig. 6 is a schematic drawing of a lighting device.
Fig. 7 is a schematic cross-sectional view of a lighting device.

### DESCRIPTION OF SYMBOLS

- 1: display
- 3: pixel
- 5: scanning line
- 6: data line
- 7: electrical power line
- 10: organic EL element
- 11: switching transistor
- 12: operating transistor
- 13: capacitor
- A: display section
- B: control section
- 107: glass substrate having a transparent electrode
- 106: organic EL layer
- 105: cathode
- 102: glass cover
- 108: nitrogen gas
- 109: desiccant

### MOST PREFERRED EMBODIMENTS TO CARRY OUT THE INVENTION

It is assumed that an injection of positive holes is smoothly conducted, since a compound represented by Formula (II) of the present invention has low HOMO and low LUMO levels. Then the inventors found that when a compound having a specific high range of the HOMO and the LUMO levels is employed as a host compound in an element in which a phosphorescent compound represented by Formula (II) is used as a dopant, the above-mentioned issue can be solved, whereby the inventors achieved the inventions described in claims 1-7. That is, it is assumed that, since positive holes were injected into the dopant in a light-emitting layer, while electrons were injected into the host compound, the electric charges did not remain in the light-emitting layer, and thus the lowering of voltage was achieved.

In the following, requirements for each constituent of the present invention will be detailed.

Initially, the HOMO and the LUMO levels of the present invention will be explained.

In the present invention, the values of the HOMO and the LUMO levels denote the values obtained by calculations using Gaussian 98 (Gaussian 98, Revision A. 11. 4, M.J.Frisch, et al, Gaussian, Inc., Pittsburg PA, 2002), which is software for a molecular orbital calculation, and produced by Gaussian Inc. The values of the HOMO and the LUMO levels of the host compound of the present invention are defined as values (a converted value in eV unit) calculated via structure optimization employing B3LYP/6-31G* as a key word. And the values of the HOMO and the LUMO levels of the phosphorescent compound of the present invention are defined as values (a converted value in eV unit) calculated via structure optimization employing B3LYP/LanL2DZ as a key word. The reason for the calculated value being considered to be valid is that the calculated value obtained by the above method is in good agreement with the experimental one.

In the present invention a "lower HOMO level" denotes that an absolute value of the HOMO level is lower. For example, in a case where a compound A and a compound B have the HOMO levels of -5.45 eV and -5.30 eV respectively, a compound B is said to have the lower HOMO level compared to a compound A. And a "lower LUMO level" denotes that an absolute value of the LUMO level is lower. For example, in a case where a compound A and a compound B have the LUMO levels of -1.12 eV and -0.85 eV respectively, a compound B is said to have the lower LUMO level compared to a compound A.

A light-emitting layer of the organic EL element of the present invention incorporates a host compound and a phosphorescent compound. The mixing ratio of the phosphorescent compound to the host compound, which is a main component in the light-emitting layer, is preferably regulated to a range of 0.1 to less than 30% in weight.

Next, the phosphorescent compound, represented by a Formula (II) of the invention described in claims 1-7, will be explained.

The phosphorescent compound represented by Formula (II) has preferably the HOMO and the LUMO levels of -4.80 to - 3.50, and -0.80 to 1.00 eV, respectively.

R₁ and R₂ each represents a substituent. Examples of such a substituent include an alkyl group (for example, a methyl group, an ethyl group, a propyl group, an isopropyl group, a tert-butyl group, a pentyl group, a hexyl group, an octyl group, a dodecyl group, a tridecyl group, a tetradecyl group, and a pentadecyl group), a cycloalkyl group (for example, a cyclopentyl group and a cyclohexyl group), an alkenyl group (for example, a vinyl group and an allyl group), an alkynyl group (for example, an ethynyl group and a propargyl group), an aromatic hydrocarbon ring group (also called an aromatic carbon ring group or an aryl group such as a phenyl group, a p-chlorophenyl group, a mesityl group, a tolyl group, a xylyl group, a naphthyl group, an anthryl group, an azulenyl group, an acenaphthenyl group, fluorenyl group, a phenanthryl group, an indenyl group, a pyrenyl group, or a biphenyl group), an aromatic heterocyclic group (for example, a pyridyl group, a pyrimidinyl group, a furyl group, a pyrrolyl group, an imidazolyl group, a benzimidazolyl group, a pyrazolyl group, a piradinyl group, a triazolyl group (for example, a 1,2,4-triazole-1-yl group and a 1,2,3-triazole-1-yl group), an oxazolyl group, a benzoxazolyl group, a thiazolyl group, an isooxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolynyl group, a diazacarbazoyl group (which shows that one of the carbon atoms which constitute a carboline ring of the above carbolinyl group is replaced with a nitrogen atom), a quinoxythalinyl group, a pyridazinyl group, a triazinyl group, a quinazolinyl group, a phthalazinyl group), a heterocyclic group (for example, a pyrrolidinyl group, an imidazolidyl group, a morpholyl group, and an oxazolidyl group), an alkoxy group (for example, a methoxy group, an ethoxy group, a propyloxy group, a pentyloxy group, a hexyloxy group, an octyloxy group, and a dodecyloxy group), a cycloalkoxy group (for example, a cyclopentyloxy group and a cyclohexyloxy group), an aryloxy group (for example, a phenoxy group and a naphthyloxy group), an alkylthio group (for example, a methylthio group, an ethylthio group, a propylthio group, a pentylthio group, a hexylthio group, an octylthio group, and a dodecylthio group), a cycloalkylthio group (for example, a cyclopentylthio group and a cyclohexylthio group), an arylthio group (for example, a phenylthio group and a naphthylthio group), an alkoxycarbonyl group (for example, a methyloxycarbonyl group, an ethyloxycarbonyl group, a butyloxycarbonyl group, an octyloxycarbonyl group, and a dodecyloxycarbonyl group), an aryloxycarbonyl group (for example, a phenyloxycarbonyl group and a naphthyloxycarbonyl group), a sulfamoyl group (for example, an aminosulfonyl group, a methylaminosulfonyl group, a dimethylaminosulfonyl group, a butylaminosulfonyl group, a hexylaminosulfonyl group, a cyclohexylaminosulfonyl group, an octylaminosulfonyl group, a dodecylaminosulfonyl group, a phenylaminosulfonyl group, a naphthylaminosulfonyl group, and a 2-pyridylaminosulfonyl group), an acyl group (for example, an acetyl group, an ethylcarbonyl group, a propylcarbonyl group, a pentylcarbonyl group, a cyclohexylcarbonyl group, an octylcarbonyl group, a 2-ethylhexylcarbonyl group, a dodecylcarbonyl group, a phenylcarbonyl group, a naphthylcarbonyl group, a pyridylcarbonyl group), an acyloxy group (for example, an acetyloxy group, an ethylcarbonyloxy group, a butylcarbonyloxy group, an octylcarbonyloxy group, a dodecylcarbonyloxy group, and a phenylcarbonyloxy group), an amido group (for example, a methylcarbonylamino group, an ethylcarbonylamino group, a dimethylcarbonylamino group, a propylcarbonylamino group, a pentylcarbonylamino group, a cyclohexylcarbonylamino group, a 2-ethylhexylcarbonylamino group, an octylcarbonylamino group, a dodecylcarbonylamino group, a phenylcarbonylamino group, and a naphthylcarbonylamino group), a carbamoyl group (for example, an aminocarbonyl group, a methylaminocarbonyl group, a dimethylaminocarbonyl group, a propylaminocarbonyl group, a pentylaminocarbonyl group, a cyclohexylaminocarbonyl group, an octylaminocarbonyl group, a 2-ethylhexylaminocarbonyl group, a dodecylaminocarbonyl group, a phenylaminocarbonyl group, a naphthylaminocarbonyl group, and a 2-pyridylaminocarbonyl group), an ureido group (for example, a methylureido group, an ethylureido group, a pentylureido group, a cyclohexylureido group, an octylureido group, a dodecylureido group, a phenylureido group, a naphthylureido group, and a 2-pyridylaminoureido group), a sulfinyl group (for example, a methylsulfinyl group, an ethylsulfinyl group, a butylsulfinyl group, a cyclohexylsulfinyl group, a 2-ethylhexylsulfinyl group, a docecylsulfinyl group, a phenylsulfinyl group, a naphthylsulfinyl group, and a 2-pyridylsulfinyl group), an alkylsulfonyl group (for example, a methylsulfonyl group, an ethylsulfonyl group, a butylsulfinyl group, a cyclohexylsulfonyl group, a 2-ethylhexylsulfonyl group, and a dodecylsulfonyl group), an arylsulfonyl group or a heteroarylsulfonyl group (for example, a phenylsulfonyl group, a naphthylsulfonyl group, and a 2-pyridylsulfonyl group), an amino group (for example, an amino group, an ethylamino group, a dimethylamino group, a butylamino group, a cyclopentylamino group, a 2-ethylhexylamino group, a dodecylamino group, an anilino group, a naphthylamino group, and a 2-pyridylamino group), a cyano group, a nitro group, a hydroxyl group, a mercapto group, and a silyl group (for example, a trimethylsilyl group, a triisopropylsilyl group, a triphenylsilyl group, and a phenyldiethylsilyl group). These substituents may be substituted with the above substituents. Further, these substituents may be bound together to form a ring.

R₃ represents a hydrogen atom or a substituent

Z represents a non-metal atom group necessary to form a 5 to 7-membered ring. Examples of 5 to 7-membered ring formed by Z include a benzene ring, a naphthalene ring, a pyridine ring, a pyrimidine ring, a pyrrole ring, a thiophene ring, a pyrazole ring, an imidazole ring, an oxazole ring, and thiazole ring. Of these, a benzene ring is preferred.

L₁, together with X₁ and X₂, represents an atom group necessary to form a bidentate ligand. Specific examples of the bidentate ligand, represented by X₁-L₁-X₂, include substituted or non-substituted, phenylpyridine, phenylpyrazole, phenylimidazple, phenyltriazole, phenyltetrazole, pyrazabole, picolinic acid, and acetylacetone. The above groups may be further substituted with the above-described substituent.

m1 is an integer of 1 to 3, and m2 is an integer of 0 to 2, provided that a sum of m1 and m2 is 2 or 3. Of these, m2 is preferably 0. As a metal represented by M₁, a transition metal element (also simply referred to as a transition metal) of Group 8 to 10 of the Periodic Table of the Elements is employed, of which iridium and platinum are preferred, and iridium is more preferred. The phosphorescent compound, represented by Formula (II), may or may not have a polymerizable group or a reactive group.

The substituent represented by R₂ of Formula (II) is represented by Formula (III) below
Formula (III) :

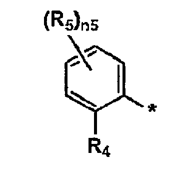

In Formula (III), R₄ represents a substituent having a steric parameter (Es) less than -0.5. R₅ represents the same as R₁. n5 is an integer of 0 - 4. Here, (*) is a bonding position.

"Es value", as described herein, refers to a steric parameter derived from chemical reactivity. It is possible to describe that a decrease in this value indicates that the substituent becomes spatially more bulky.

Es value will now be described. It is common knowledge that in a hydrolysis reaction of esters under acidic conditions, effects for the progress of the reaction may be considered to be only caused by the steric hindrance. Based on this, the value which numerically expresses the steric hindrance is Es value.

Es value of substituent X may be obtainable as follows. Reaction rate constant kX of the following chemical reaction in which α-position mono-substituted acetate, which is derived from α-position mono-substituted acetic acid prepared by substituting one hydrogen atom of the methyl group of acetic acid with substituent X, undergoes hydrolysis under acidic conditions, is obtained.

X-CH₂COOR_{X} + H₂O → X - CH₂COOH- + R_{X}OH

Reaction rate constant kH of the following reaction (R_{X} is the same as R_{Y}) in which acetate corresponding to the above α-position mono-substituted acetate undergoes hydrolysis under acetic conditions, is also obtained.

CH₃COOR_{Y} + H₂O → CH₃COOH + RyOH

Subsequently, Es is obtained via the following formula.

Es = log (kX/kH)

The reaction rate decreases due to steric hindrance of substituent X. As a result, since kX < kH is held, Es value commonly becomes negative. In practice, when Es value is obtained, two reaction rate constants, namely kX and kH, are determined and it is calculated based on the above formula.

Specific examples of Es value are detailed in Unger, S. H., Hansch, C., Prog. Phys. Org. Chem. 12, 91 (1976). Further, specific numerical values are also described in "Yakubutsu no Kozo Kassei Sokan (Structural Activity Correlation)" (Kagaku no Ryoiki Zokan No. 122, Nanko Do), and "American Chemical Society Professional Reference Book, 'Exploring QSAR' p. 81, Table 3-3". Table 1 below shows some of them.

**Table 1**

| Substituent | Es Value | Substituent | Es Value |
|---|---|---|---|
| H | 0 | CH₂OCH₃ | -1.43 |
| F | -0.46 | CH₂NO₂ | -2.71 |
| Cl | -0.97 | CH₂COCH₃ | -1.99 |
| Br | -1.16 | CHF₂ | -1.91 |
| I | -1.4 | CHCl₂ | -2.78 |
| CH₃ | -1.24 | CHBr₂ | -3.1 |
| C₂H₅ | -1.31 | CHOHCH₃ | -1.15 |
| n-C₃H₇ | -1.6 | CF₃ | -2.4 |
| n-C₄H₉ | -1.63 | CCl₃ | -3.3 |
| i-C₄H₉ | -2.17 | CBr₃ | -3.67 |
| s-C₄H₉ | -2.37 | C(C₆H₅)₃ | -5.92 |
| t-C₄H₉ | -2.78 | CHCH₃ | -2.84 |
| cyclo-C₄H₇ | -1.3 | CN | -0.51 |
| n-C₅H₁₁ | -1.64 | OH | -0.55 |
| i-C₅H₁₁ | -1.59 | OCH₃ | -0.55 |
| CH(C₂H₅) | -3.22 | SH | -1.07 |
| cyclo-C₆H₁₁ | -2.03 | SCH₃ | -1.07 |
| CH₂F | -1.48 | SF₅ | -2.91 |
| CH₂Cl | -1.48 | NH₂ | -0.61 |
| CH₂Br | -1.51 | | |
| CH₂I | -1.61 | | |
| CH₂OH | -1.21 | | |

Further, it should be noted that the Es value, which is defined in the present invention, is not determined while a methyl group is 0, but is determined while a hydrogen atom to be 0, whereby the Es value of the present invention is a value which is obtained by subtracting 1.24 from the Es value determine while a methyl group is 0.

In the present invention, R₄ is a substituent having an Es value of -0.5 or less, preferably it is between -7.0 and - 0.6, and it is more preferably between -7.0 and -1.0.

Further, in the present invention, in the case in which keto-enol tautomers are present in R₄, the Es value of the keto portion is determined via conversion as an enol isomer. In cases in which other tautomers are present, Es values are determined based on the same conversion method.

Examples of phosphorescent compounds of the present invention represented by Formula (II) are shown below. However, the present invention is not limited by them.

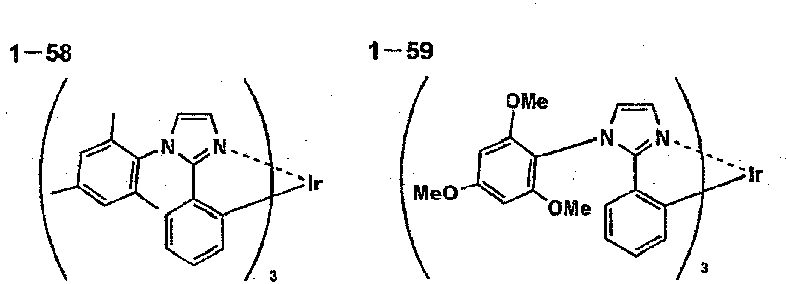

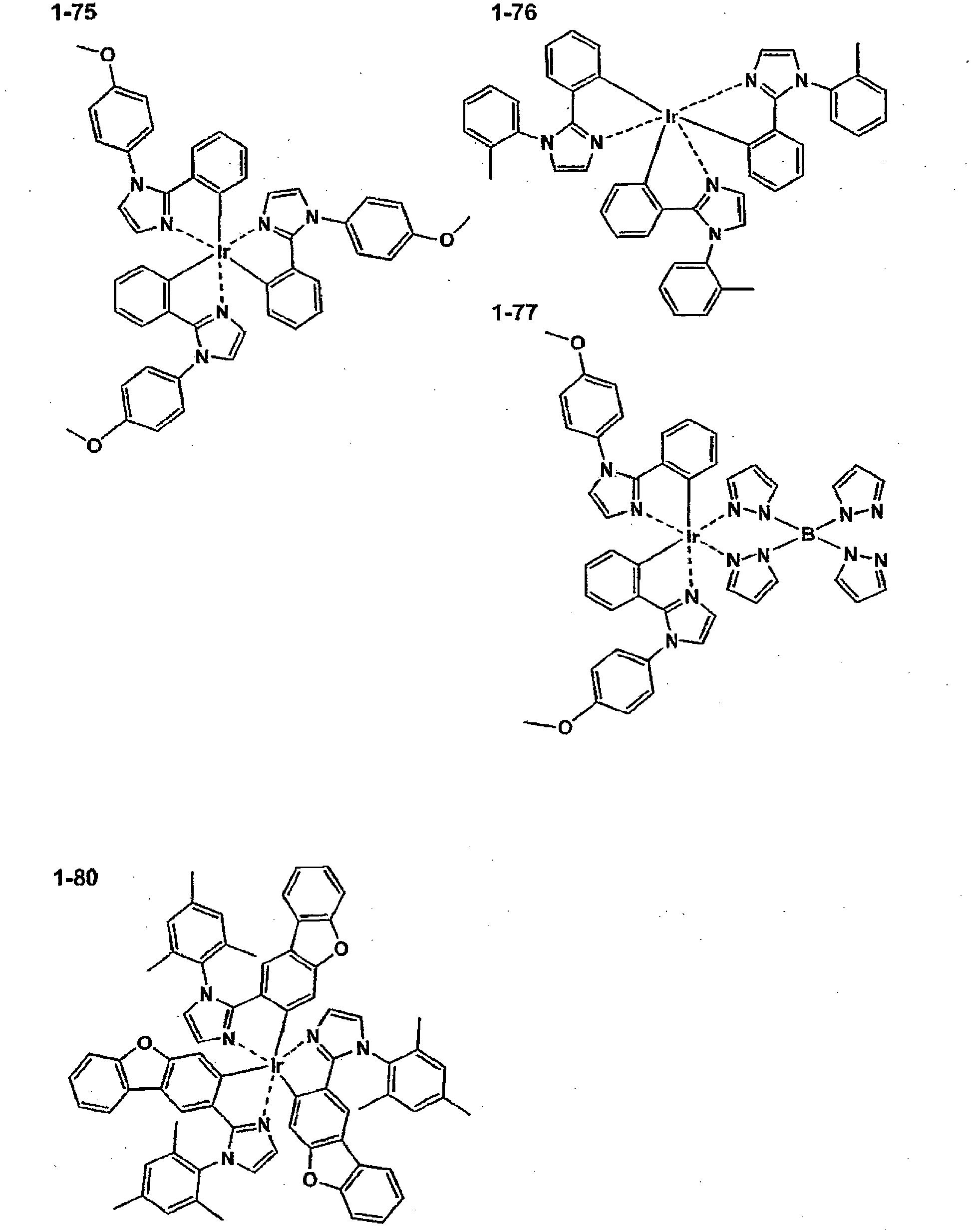

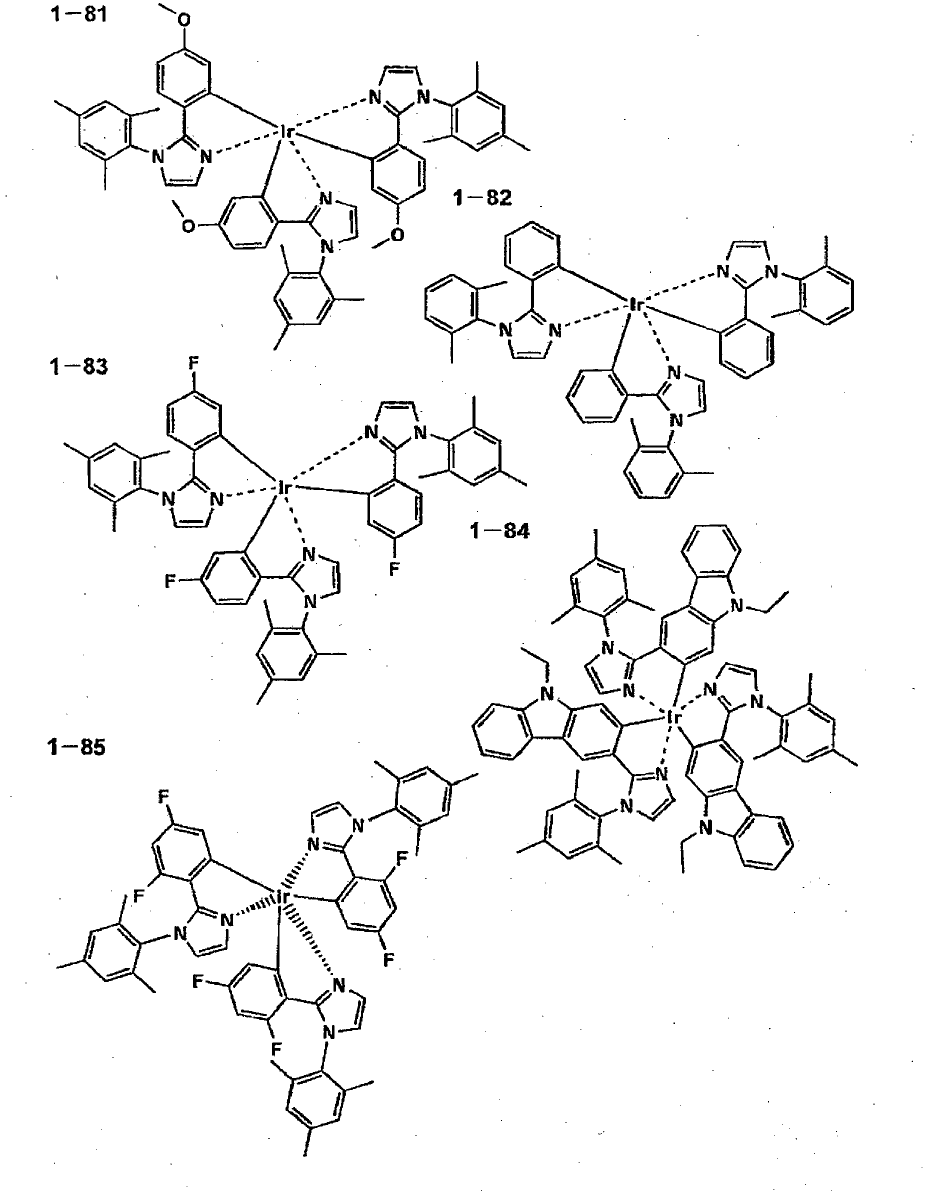

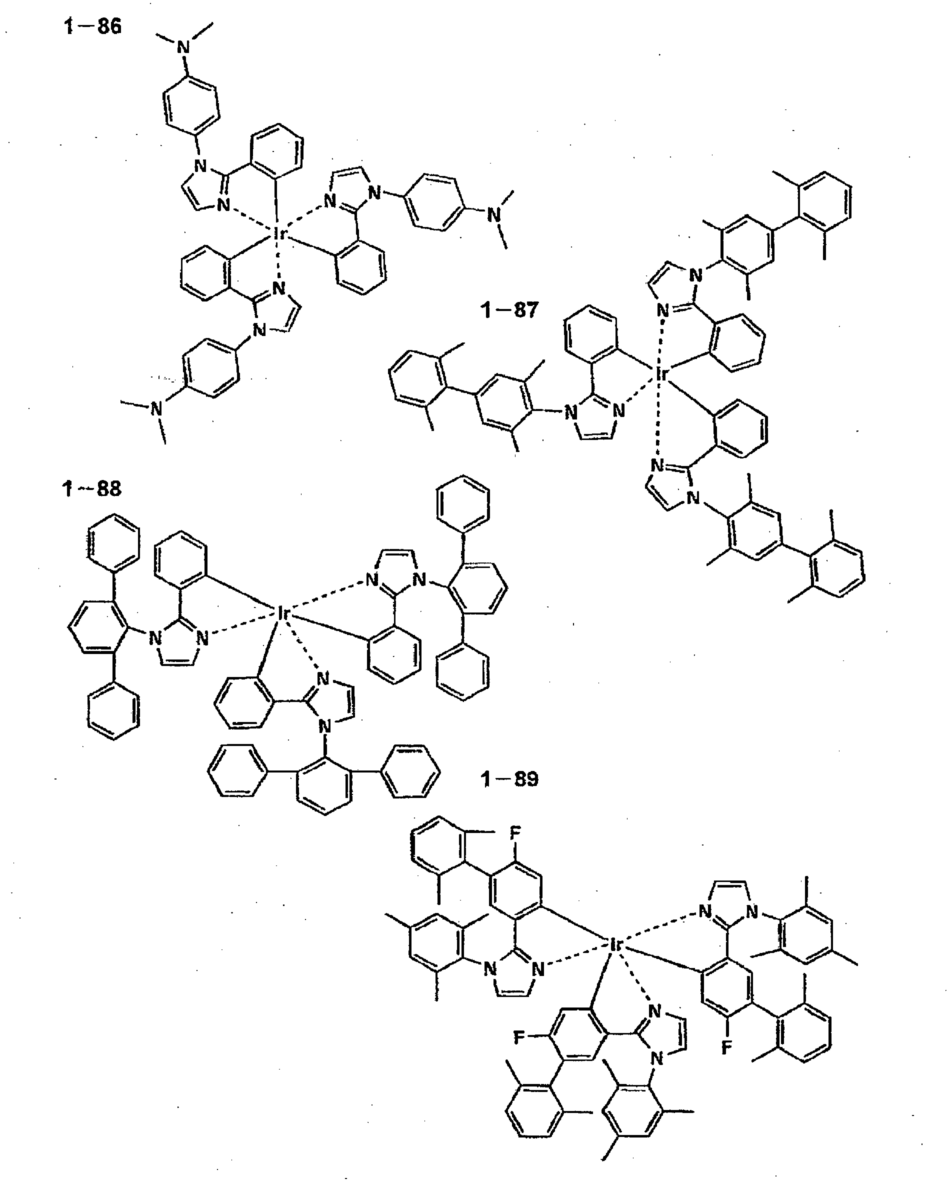

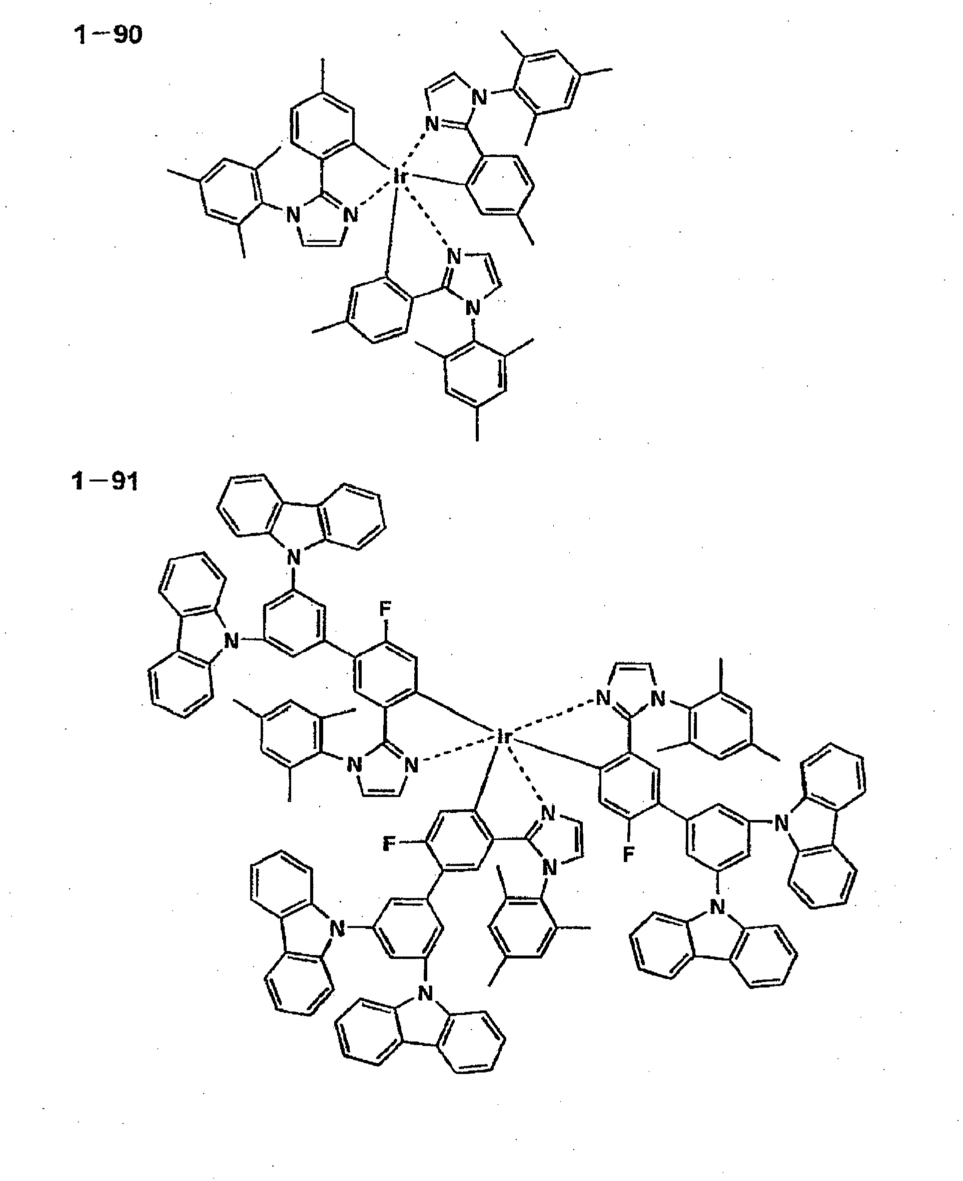

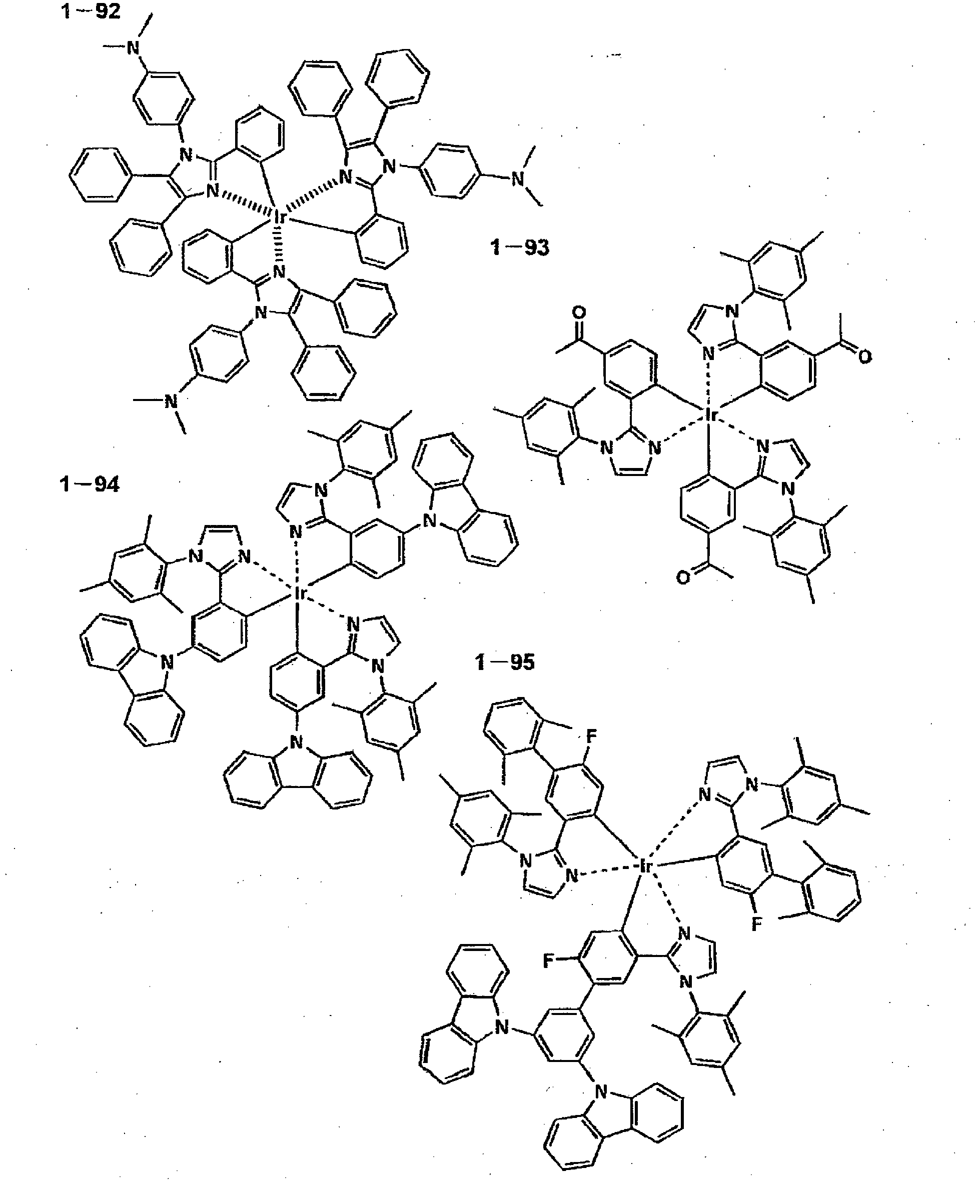

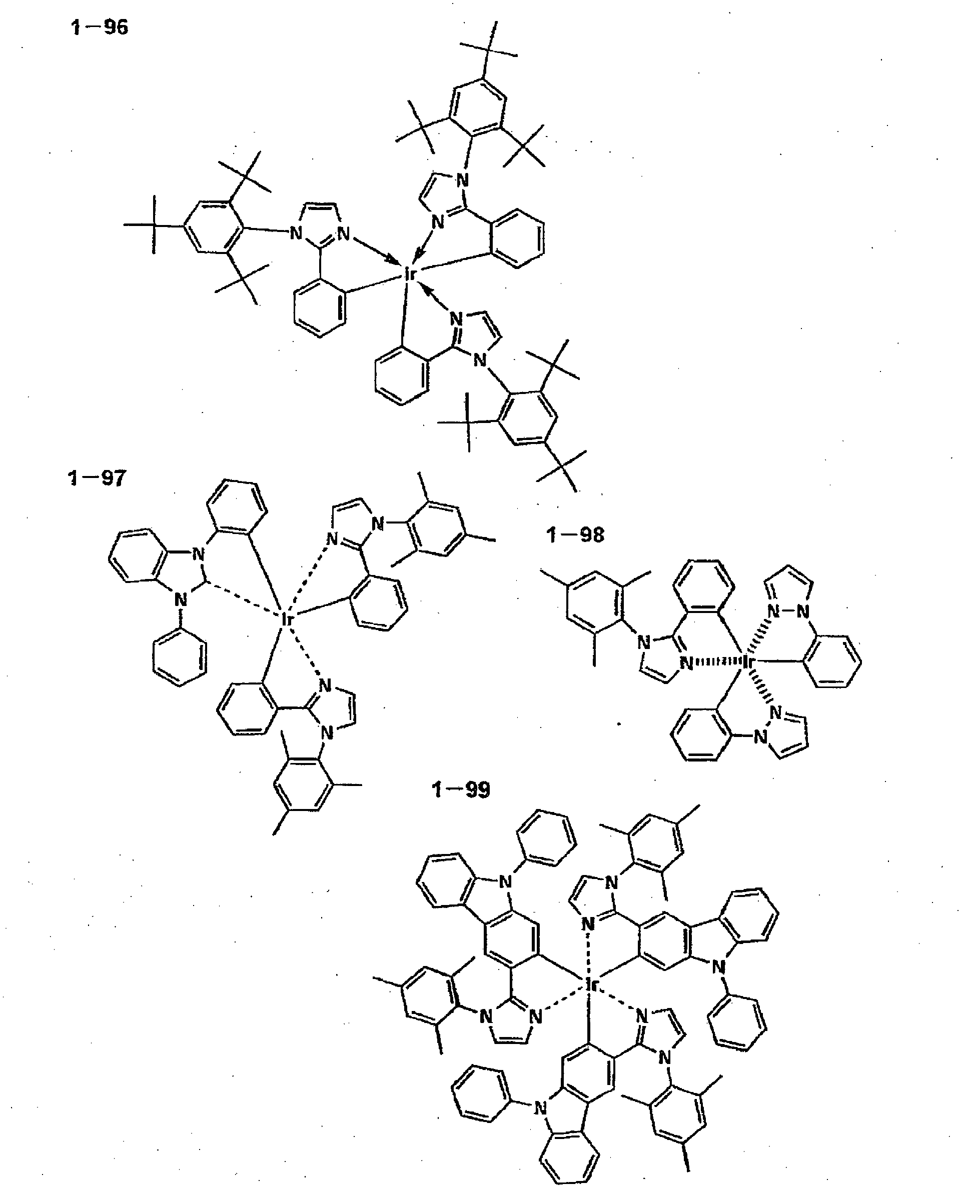

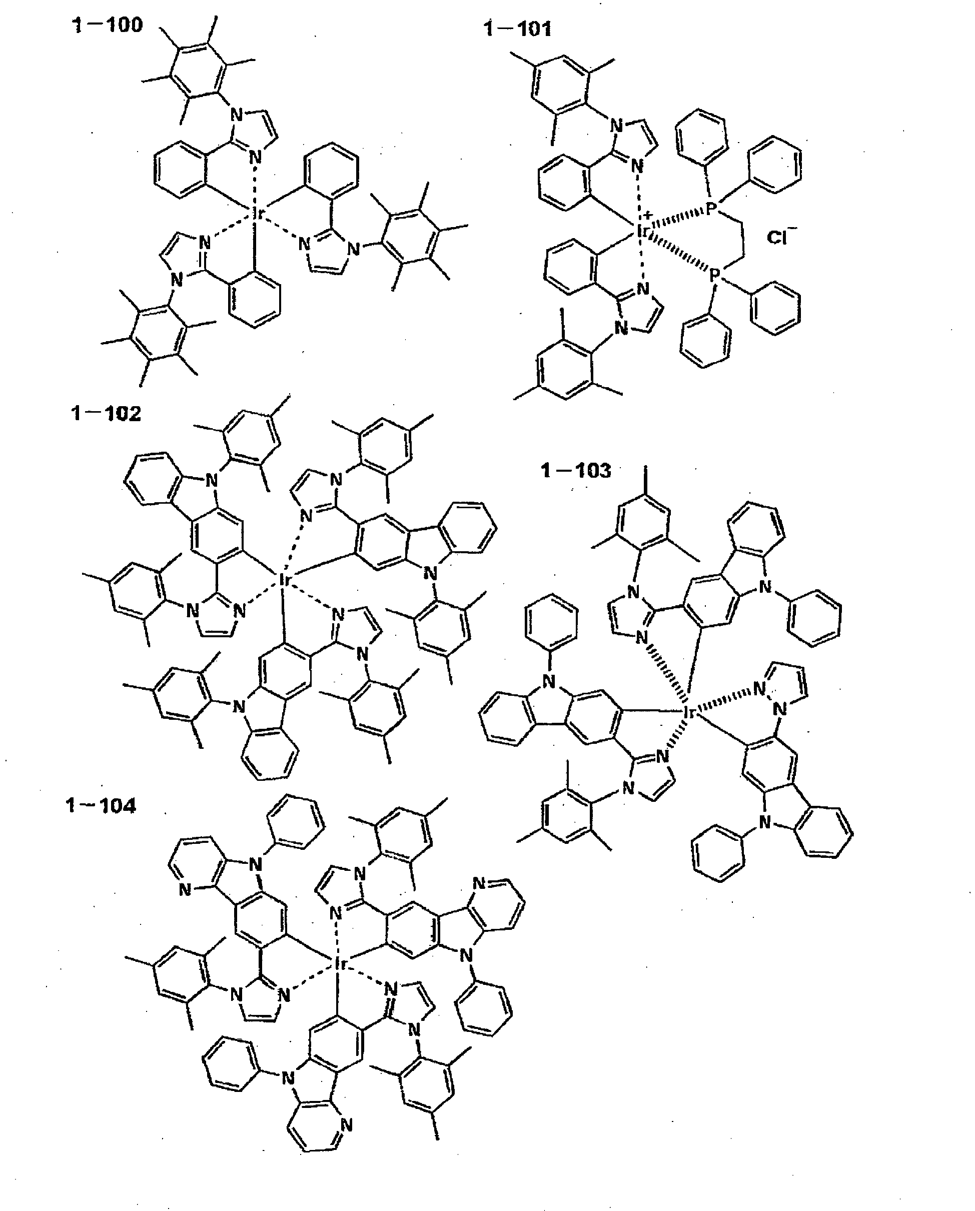

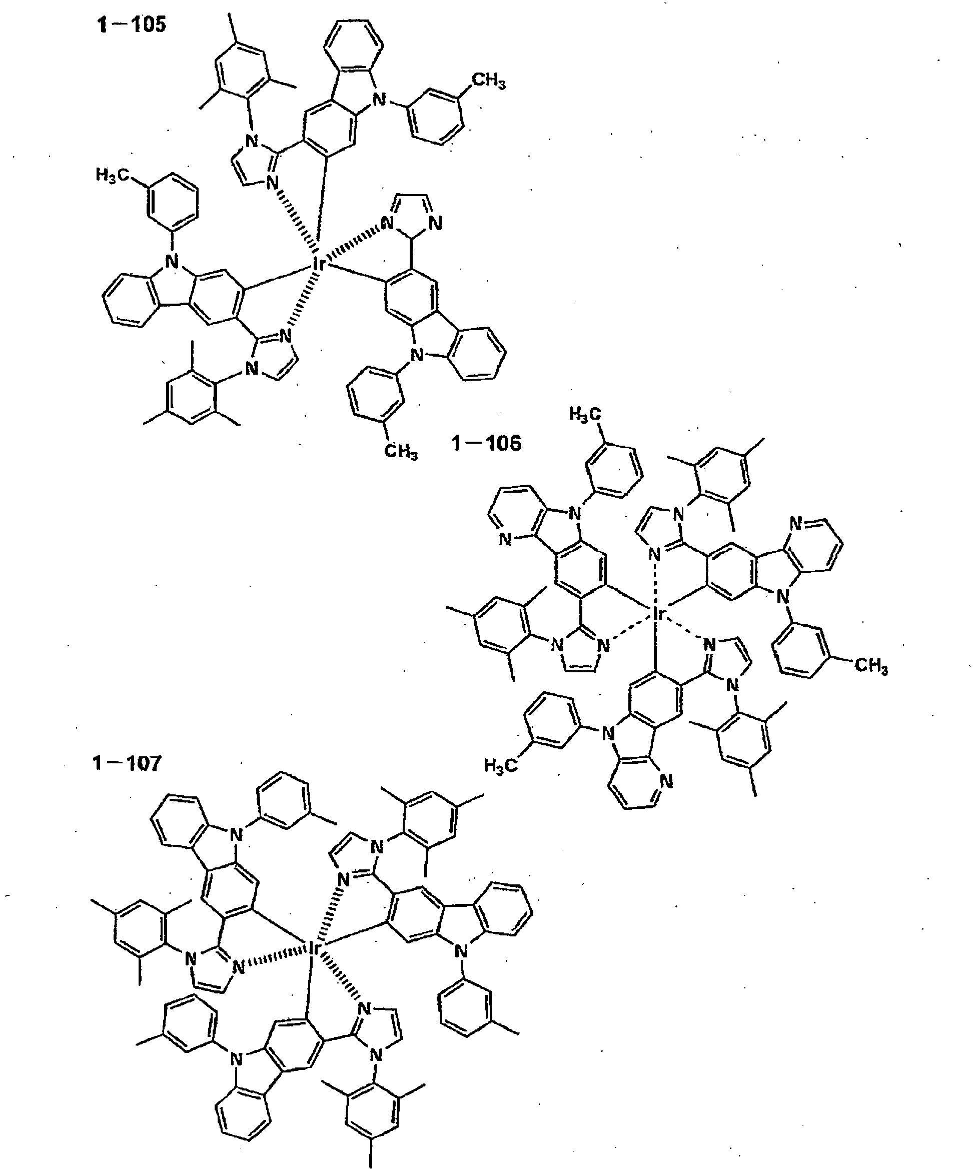

Metal complexes according to an organic EL element material of this invention can be synthesized by applying a method described in such as Organic Letter, vol. 3, No. 16, pp. 2579 - 2581 (2001), Inorganic Chemistry vol. 30, No. 8, pp. 1685 - 1687 (1991), J. Am. Chem. Soc., vol. 123, p. 4304 (2001), Inorganic Chemistry vol. 40, No. 7, pp. 1704 - 1711 (2001), Inorganic Chemistry vol. 41, No. 12, pp. 3055 - 3066 (2002), New Journal of Chemistry, vol. 26, p.1171 (2002), European Journal of Organic Chemistry Vol. 4, pp. 695 - 709 (2004), and reference documents described in these documents.

Next, the host compound of the inventions according to Items 1 to 4, and 13 to 18 will be explained.

The host compound, employed in the present invention, has the HOMO level of -7.20 to -5.42 eV, and the LUMO level of -2.30 to -0.50 eV. In addition, the aforesaid host compound is a compound, among those incorporated in the light-emitting layer, having a phosphorescent quantum yield of a phosphorescent emission of less than 0.01 at a room temperature (25 °C).

The host compound, employed in the present invention is preferably a compound having a phosphorescence 0-0 band of a wavelength shorter than that of a phosphorescent compound which is employed in combination. In a case where the phosphorescent compound, containing a blue light-emitting component exhibiting a phosphorescence 0-0 band of not more than 470 nm, is employed, the host compound preferably exhibits a phosphorescence 0-0 band of not more than 460 nm.

The phosphorescence 0-0 band (nm) of the metal complex of the present invention is explained below. Firstly, the measurement of phosphorescence spectrum is described.

A host compound to be measured is dissolved in a mixed solvent of well-deoxygenated ethanol/methanol (4/1 by volume) and placed in a cell for phosphorescence measurement, followed by irradiation of exciting light at a liquid nitrogen temperature of 77 K to measure an emission spectrum 100 ms after completion of the irradiation of exciting light. It is conceivable that since phosphorescence features a longer emission life than fluorescence, most of the light remaining after the 100 ms have elapsed is phosphorescence. Incidentally, a compound exhibiting a phosphorescence life of shorter than 100 ms may be measured by shortening a delay time. However, in cases when shortening the delay time to the extent that the shortened delay time is not distinguished from the life of fluorescence, a problem occurs in that phosphorescence and fluorescence each are indistinguishable, and therefore it is necessary to select an appropriate delay time capable of distinguishing therebetween.

For a compound insoluble in the solvent system described above, any appropriate solvent, which can dissolve the compound, may be employed (it is not substantially problematic since a solvent effect on the phosphorescence wavelength in the above measurement method is negligible.).

Subsequently, a method of determining the 0-0 band is described. In the present invention, the 0-0 band is defined as the maximum emission wavelength appearing in the shortest wavelength portion in the phosphorescence spectrum chart obtained via the above measurement method.

Since the intensity of a phosphorescence spectrum is generally weak, when the spectrum is magnified, it becomes difficult, in some cases, to distinguish between a noise band and a signal peak. In such a case, it is possible to determine a targeted signal peak in such a manner that a light emission spectrum generated right after irradiation of excitation light (for convenience, referred to as "stationary light spectrum") is magnified, which is then superimposed on another magnified light emission spectrum generated at 100 ms after irradiation of excitation light (for convenience, referred to as "phosphorescence spectrum"), to detect a peak wavelength from the stationary light spectrum originated in the phosphorescence spectrum. It is also possible to detect a signal peak wavelength by separation of the noise band and the signal peak via a smoothing treatment. The smoothing method by Savitzky and Golay may be applied as the smoothing treatment.

The host compound, employed in the present invention is not particularly limited by its chemical structure, and may be a low molecular weight compound or a high molecular weight compound having a repeating unit, and may further be a low molecular weight compound having a polymerizable group such as a vinyl group and an epoxy group (an vapor-deposition polymerizable host compound). Among these host compounds, preferable are compounds having hole transporting capability and electron transporting capability, while preventing elongation of the emission wavelength,and further having a higher Tg (a glass transition temperature).

Host compounds according to claims 1-7 of the present invention are not specifically limited in terms of the structure. Examples include a carbazole derivative, a triarylamine derivative, an aromatic borane derivative, a nitrogen-containing heterocyclic derivatives, a thiophene derivative, a furan derivative, a compound having a basic skeleton such as an oligoallylene compound, or a derivative having a ring structure wherein at least one of the carbon atoms of a hydrocarbon ring constituting a carboline derivative or a carboline ring of the carboline derivative is substituted with a nitrogen atom.

A host compound according to claims 1-7 of the present invention is preferably represented by Formula (2).

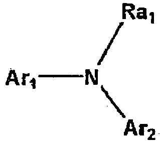

In Formula (2), Ar₁ and Ar₂ each represent an aromatic hydrocarbon group or an aromatic heterocyclic group. Examples of aromatic hydrocarbon groups (aromatic carbon rings or aryl groups) are, a phenyl group, a p-chlorophenyl group, a mesityl group, a tolyl group, a xylyl group, a naphtyl group, an anthryl group, an azulenyl group, an acenaphthenyl group, a fluorenyl group, a phenanthryl group, an indenyl group, a pyrenyl group, and a biphenyl group. These groups may have a substituent which will be described later.

Examples of aromatic heterocyclic groups represented by Ar₁ and Ar₂ are, a pyridyl group, a pyrimidinyl group, a furyl group, a pyrrolyl group, an imidazolyl group, a benzimidazolyl group, a pyrazolyl group, a piradinyl group, a triazolyl group (for example, a 1,2,4-triazole-1-yl group and a 1,2,3-triazole-1-yl group), an oxazolyl group, a benzoxazolyl group, a thiazolyl group, an isooxazolyl group, an isothiazolyl group, a furazanyl group, a thienyl group, a quinolyl group, a benzofuryl group, a dibenzofuryl group, a benzothienyl group, a dibenzothienyl group, an indolyl group, a carbazolyl group, a carbolynyl group, a diazacarbazoyl group (which shows that one of the carbon atoms which constitute a carboline ring of the above carbolinyl group is replaced with a nitrogen atom), a quinoxythalinyl group, a pyridazinyl group, a triazinyl group, a quinazolinyl group, a phthalazinyl group.

These groups may have a substituent. The substituent includes an alkyl group (for example, a methyl group, an ethyl group, a propyl group, an isopropyl group, or a tert-butyl group), a cycloalkyl group (for example, a cyclopentyl group or a cyclohexyl group), an alkenyl group (for example, a vinyl group or an allyl group), an alkynyl group (for example, an ethynyl group), an aryl group (for example, a phenyl group or a 2,6-dimethylphenyl group), a heteroaryl group (for example, a furyl group, a thienyl group, a pyridyl group, a pyridazyl group, a pyrimidyl group, a pyrazyl group, a triazyl group, an imidazolyl group, a pyrazolyl group, a thiazolyl group, a quinazolyl group, or a phthalazyl group), a heterocyclic group (for example, a pyrrolidyl group, an imidazolydyl group, a morpholyl group, or an oxazolydyl group), an alkoxy group (for example, a methoxy group or an ethoxy group), a cycloalkoxy group (for example, a cyclopentyloxy group or a cyclohexyloxy group), an aryloxy group (for example, a phenoxy group or a naphthyloxy group), an alkylthio group (for example, a methylthio group or an ethylthio group), a cycloalkylthio group (for example, a cyclopentylthio group or a cyclohexylthio group), an arylthio group (for example, a phenylthio group or a naphthylthio group), an alkoxycarbonyl group (for example, a methyloxycarbonyl group or an ethyloxycarbonyl group), an aryloxycarbonyl group (for example, a phenyloxycarbonyl group or a naphthyloxycarbonyl group), a sulfamoyl group (for example, an aminosulfonyl group, a methylaminosulfonyl group, or a dimethylaminosulfonyl group), an acyl group (for example, an acetyl group or an ethylcarbonyl group), an acyloxy group (for example, an acetyloxy group or an ethylcarbonyloxy group), an amido group (for example, a methylcarbonylamino group, an ethylcarbonylamino group, or a dimethylcarbonylamino group), a carbamoyl group (for example, an aminocarbonyl group, a methylaminocarbonyl group, a dimethylaminocarbonyl group), a ureido group (for example, a methylureido group or an ethylureido group), an amino group (for example, an amino group, an ethylamino group, a dimethylamino group, or a diphenylamino group), a halogen atom (for example, a fluorine atom, a chlorine atom, or a bromine atom), a fluorinated hydrocarbon group (for example, a fluoromethyl group or a trifluoromethyl group), a cyano group, a nitro group, a hydroxyl group, a mercapto group, and a silyl group (for example, a trimethylsilyl group).

A nitrogen atom substituted with Ar₁ and Ar₂, together with an atom in Ar₁ and an atom in Ar₂, both of which are adjacent to the atoms substituted with the aforesaid nitrogen atom, may further form a ring. Specific structural examples of the ring are shown below.

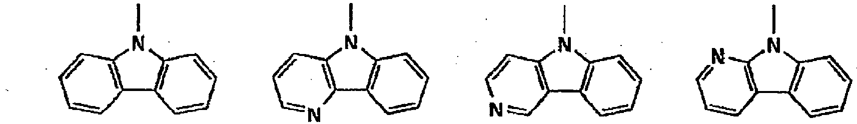

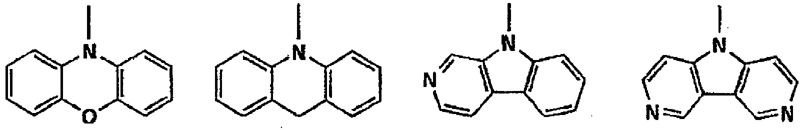

Ra₁ represents a hydrogen atom, an alkyl group, a cycloalkyl group, an aromatic hydrocarbon group, an aromatic heterocyclic group, or a heterocyclic group, each of which may have a substituent.

Examples of an alkyl group represented by Ra₁ include a methyl group, an ethyl group, a propyl group, an isopropyl group, a butyl group, an isobutyl group, a sec-butyl group, a tert-butyl group, a pentyl group, an isopentyl group, a neopentyl group, a tert-pentyl group, a hexyl group, an isohexyl group, an octyl group, a dodecyl group, a tridecyl group, a tetradecyl group, a pentadecyl group, a 2-ethylhexyl group, an undecyl group, and a tetradecyl group. Examples of a cycloalkyl group represented by Ra₁ include a cyclopentyl group, and a cyclohexyl group. Examples of an aromatic hydrocarbon group and an aromatic heterocyclic group represented by Ra₁ include an aromatic hydrocarbon group, and the like, and an aromatic heterocyclic group, and the like, all of which are cited in the above explanation for Ar₁ and Ar₂. Examples of a heterocyclic group represented by Ra₁ include a pyrrolidyl group, an imidazolydyl group, a morpholyl group, and an oxazolidyl group. Each of the above-described groups may have a substituent, and the aforesaid substituents include substituents similar to those cited as examples in the above Ar₁ and Ar₂.

Of the compounds represented by Formula (2), the compounds represented by Formulae (3) to (7) are more preferred.

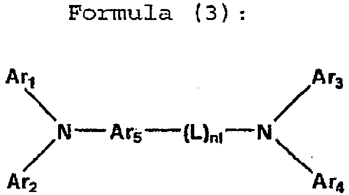

In Formula (3), each of Ar₁ to Ar₄ independently represents an aromatic hydrocarbon group or an aromatic heterocyclic group, each of which may have a substituent. Specific groups represented by Ar₁ to Ar₄ include groups similar to those listed for Ar₁ to Ar₄ in Formula (2). Further, a nitrogen atom substituted with Ar₁ and Ar₂, together with an atom in Ar₁ and an atom in Ar₂, both of which are adjacent to the atoms substituted with the aforesaid nitrogen atom, may further join to form a ring, in a similar way to Ar₁ and Ar₂ in Formula (2). Similarly, a nitrogen atom substituted with Ar₃ and Ar₄ may further form a ring.

Ar₅ represents a bivalent arylene group or a heteroarylene group, each of which may have a substituent. Examples of an arylene group or a heteroarylene group represented by Ar₅ include 1,3-phenylene, 1,4-phenylene, 1,5-naphthylene, and pyridine-2,5-diyl. L represents a bivalent linking group and n1 represents an integer of 0 to 6. Each of plural L's may be different or the same.

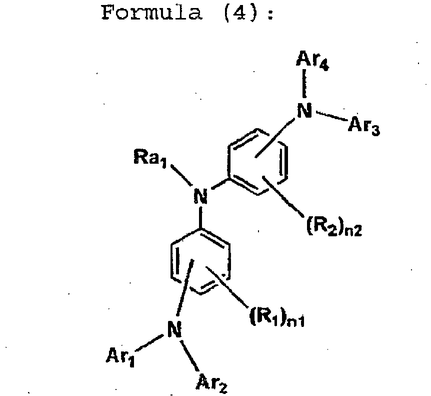

In Formula (4), R₁ and R₂ represent a substituent, and n1 and n2 represent an integer of 0 to 4. Each of Ar₁ to Ar₄ independently represents an aromatic hydrocarbon group or an aromatic heterocyclic group, each of which may have a substituent. Specific examples of groups represented by Ar₁ to Ar₄ include groups similar to those listed for Ar₁ and Ar₄ in Formula (2).

Ra₁ represents an alkyl group, a cycloalkyl group, an aromatic hydrocarbon group, an aromatic heterocyclic group, or a heterocyclic group, each of which may have a substituent. Further, a nitrogen atom substituted with Ar₁ and Ar₂, together with an atom in Ar₁ and an atom in Ar₂, both of which are adjacent to the atoms substituted with the aforesaid nitrogen atom, may further join to form a ring, in a similar way to Ar₁ and Ar₂ in Formula (2). Similarly, a nitrogen atom substituted with Ar₃ and Ar₄ may further form a ring.

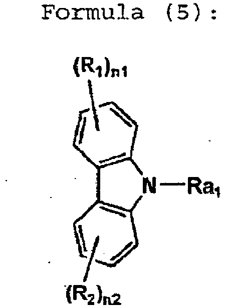

In Formula (5), Ra₁ represents a hydrogen atom, an alkyl group, a cycloalkyl group, an aromatic hydrocarbon group, an aromatic heterocyclic group, or a heterocyclic group, which may further be substituted by a substituent which above Ar₁ and Ar₂ in Formula (2) may have. Each of R₁ and R₂ represents a substituent, and n1 and n2 represent an integer of 0 to 4.

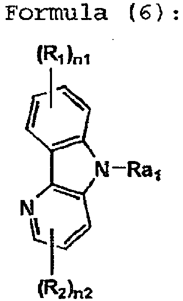

In Formula (6), Ra₁ represents a hydrogen atom, an alkyl group, a cycloalkyl group, an aromatic hydrocarbon group, an aromatic heterocyclic group, or a heterocyclic group, which may further be substituted by a substituent which above Ar₁ and Ar₂ in Formula (2) may have. Each of R₁ and R₂ represents a substituent, and n1 and n2 represent an integer of 0 to 4, and an integer of 0 to 3, respectively.

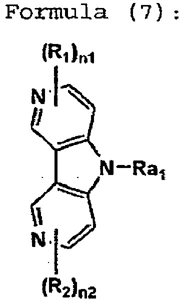

In Formula (7), Ra₁ represents a hydrogen atom, an alkyl group, a cycloalkyl group, an aromatic hydrocarbon group, an aromatic heterocyclic group, or a heterocyclic group, which may further be substituted by a substituent which above Ar₁ and Ar₂ in Formula (2) may have. Each of R₁ and R₂ represents a substituent, and n1 and n2 represent an integer of 0 to 3.

Of compounds represented by Formula (3) - (7), compounds represented by Formula (8) - (11) are more preferred.

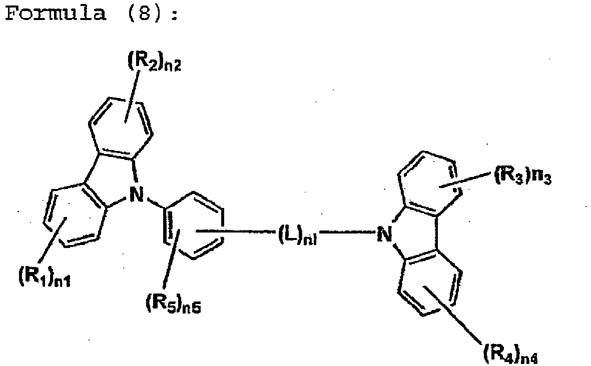

In Formula (8), each of R₁ to R₅ represents a substituent, and each of n1 to n5 represents an integer of 0 to 4. L represents a bivalent linkage, n1 represents an integer of 0 to 6, and each of plural L's may be different or the same.

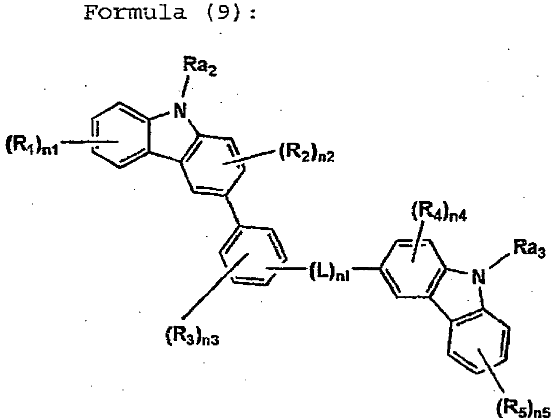

In Formula (9), R₁ to R₅ represent a substituent, n1, n3 and n5 represent an integer of 0 to 4, n2 and n4 represent an integer of 0 to 3, L represents a bivalent linking group, n1 represents an integer of 0 to 6, and each of plural L's may be different or the same. Each of Ra₂ and Ra₃ independently represents a hydrogen atom, an alkyl group, a cycloalkyl group, an aromatic hydrocarbon group, an aromatic heterocyclic group, or a heterocyclic group, which may further be substituted by a substituent which above Ar₁ and Ar₂ in Formula (2) may have.

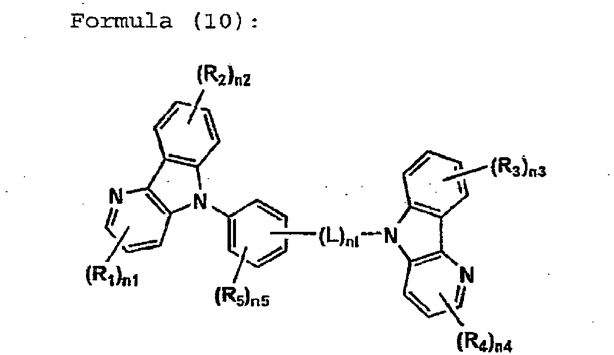

In Formula (10), R₁ to R₅ represent a substituent, n1 and n4 represent an integer of 0 to 3, and n2, n3 and n5 represent an integer of 0 to 4. L represents a bivalent linkage, n1 represents an integer of 0 to 6, and each of plural L's may be different or the same.

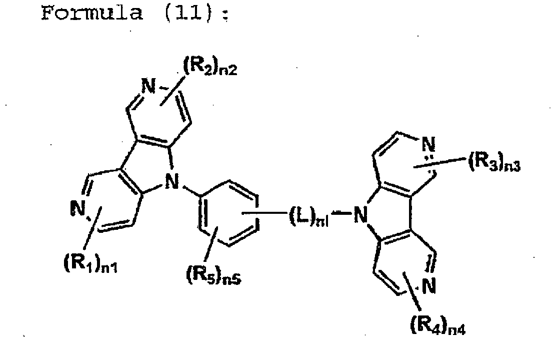

In Formula (11), R₁ to R₅ represent a substituent, n1 to n4 represent an integer of 0 to 3, and n5 represents an integer of 0 to 4. L represents a bivalent linkage, n1 represents an integer of 0 to 6, and each of plural L's may be different or the same.

In any one of the compounds represented by Formulae (3) to (11), the substituent represented by each of R₁ to R₆ is the same as the substituent which Ar₁ and Ar₂ in the above-described Formula (2) may have.

The bivalent linking group represented by L may include, in addition to a hydrocarbon group such as an alkylene group, an alkenylene group, an alkynylene group, and an arylene group; a group having a heteroatom; a bivalent linking group originated from a compound having an aromatic heterocycle (also referred to as a heteroaromatic compound) such as a thiophene-2,5-diyl group and a pyrazine-2,3-diyl group; and a chalcogen atom such as -O-, -S-, and -NR- (R represents a hydrogen atom or a substituent). Further, the aforesaid bivalent linking group may also be a group which forms a linkage through a heteroatom, such as an alkylimino group, a dialkylsilanediyl group, or a diarylgermanediyl group.

Further, as a host compound, the compound represented by Formula (12) below is preferred.

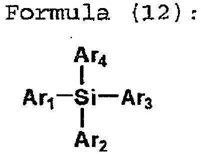

In Formula (12), each of Ar₁ to Ar₄ independently represents an aromatic hydrocarbon group or an aromatic heterocyclic group, each of which may have a substituent. Specific examples of groups represented by Ar₁ to Ar₄ include groups similar to Ar₁ and Ar₂ in Formula (2). The aforesaid substituents include those which are the same as the substituent which Ar₁ and Ar₂ in the above-described Formula (2) may have.

Further, as a host compound, the compound represented by Formula (13) below is also preferred.

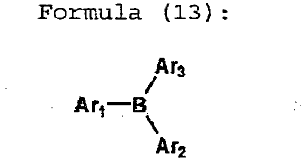

In Formula (13), each of Ar₁ to Ar₃ independently represents an aromatic hydrocarbon group or an aromatic heterocyclic group, each of which may have a substituent. Specific examples of groups represented by Ar₁ to Ar₃ include groups similar to Ar₁ and Ar₂ in Formula (2). The aforesaid substituents include those which are the same as the substituent which Ar₁ and Ar₂ in the above-described Formula (2) may have.

Listed belle specific examples employed as a host compound in the present invention.

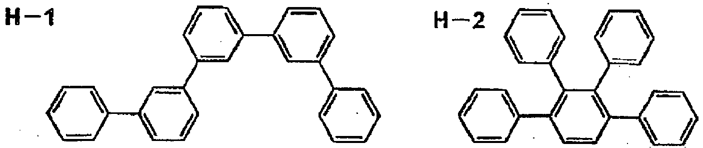

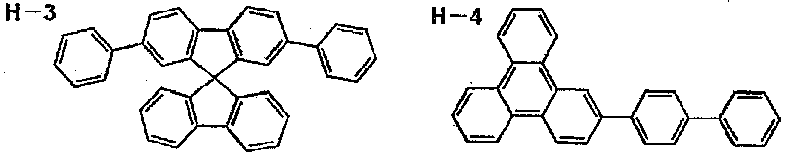

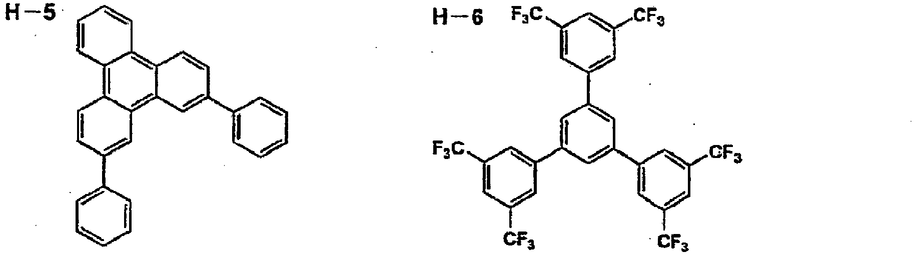

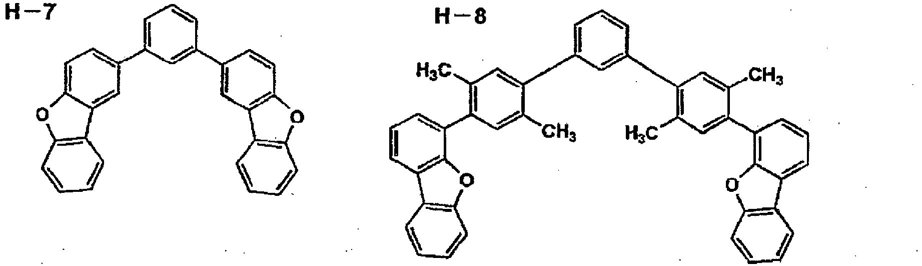

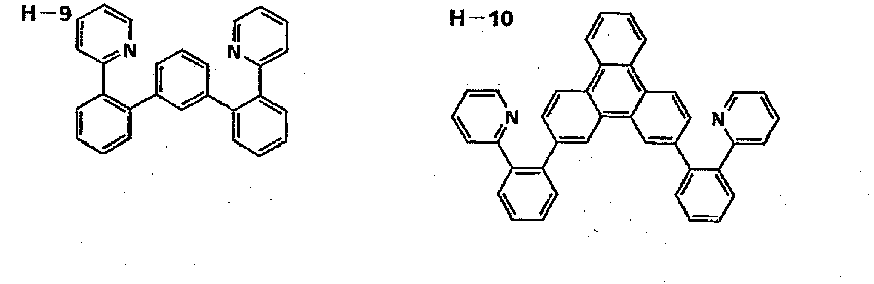

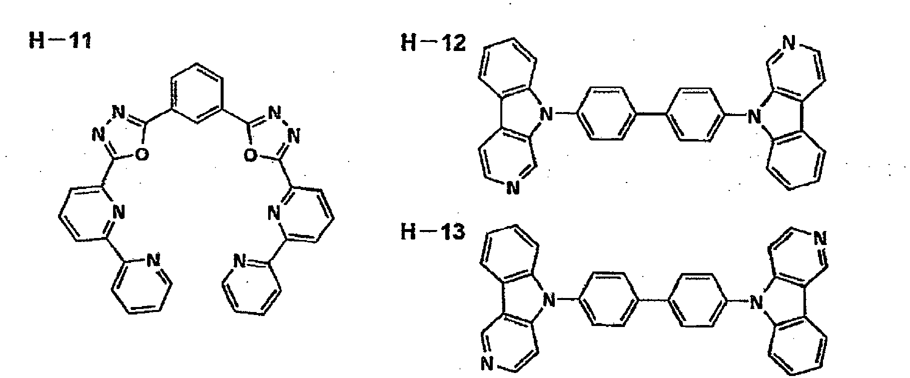

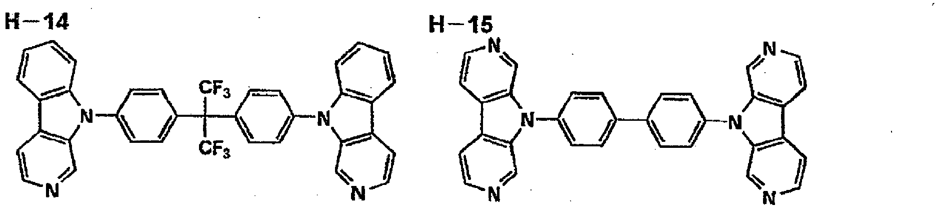

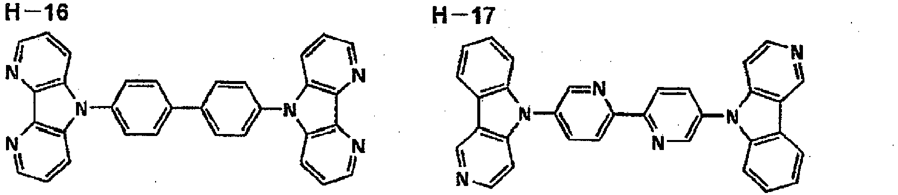

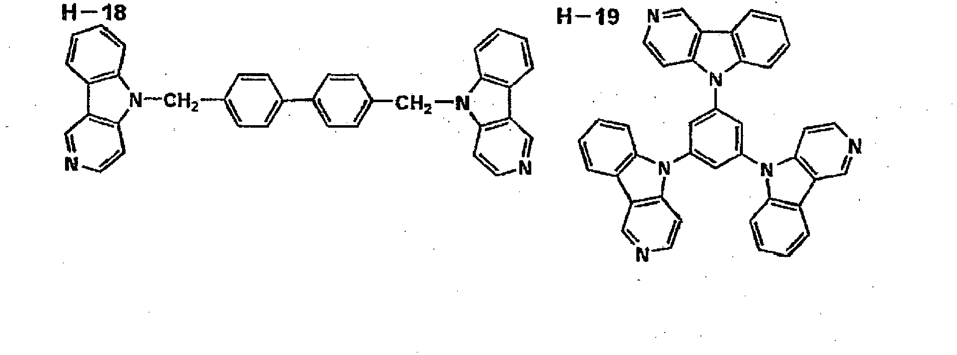

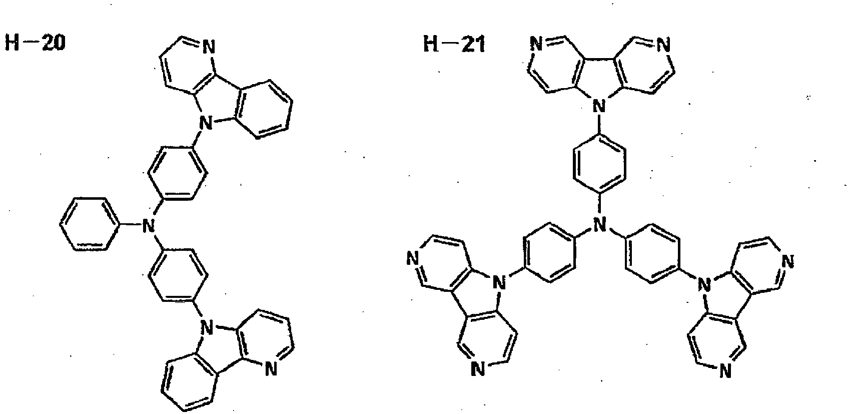

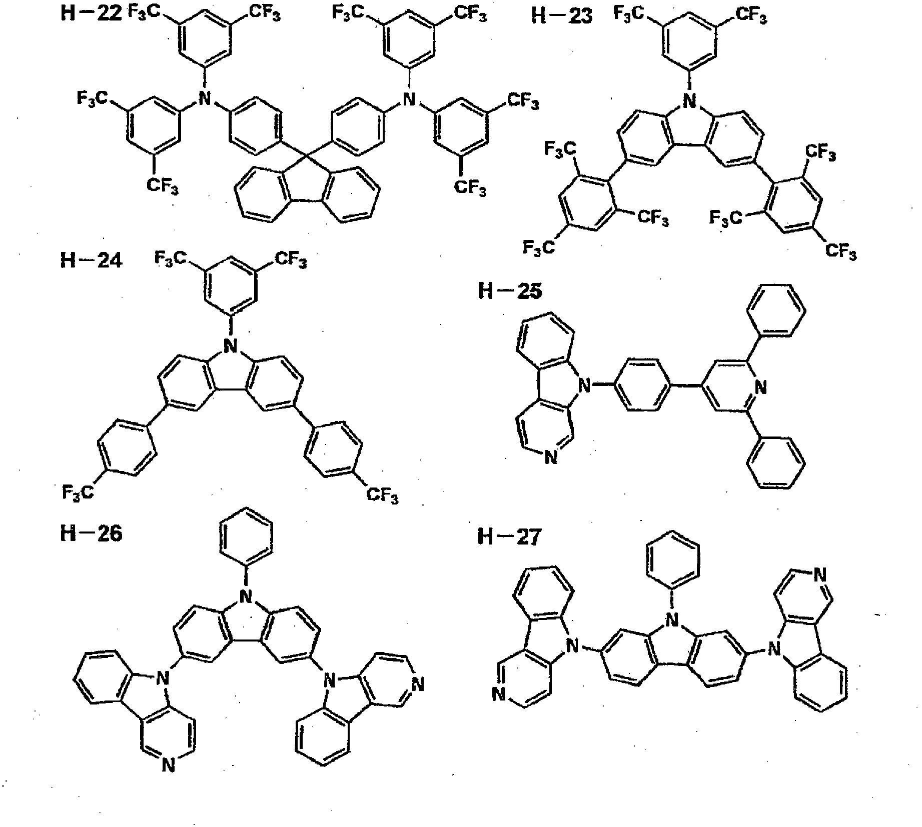

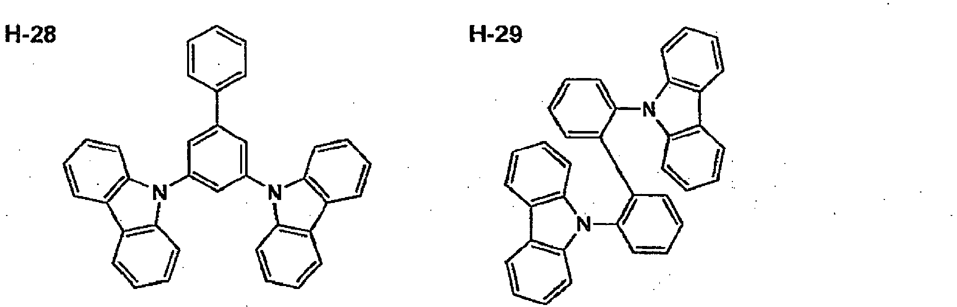

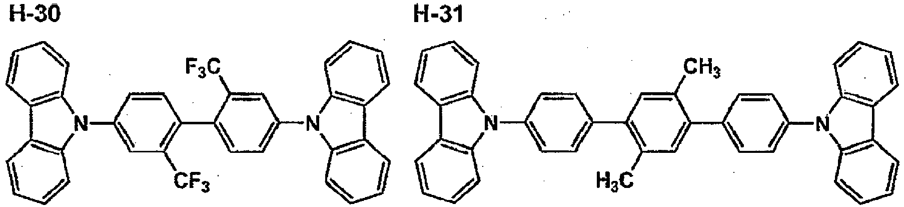

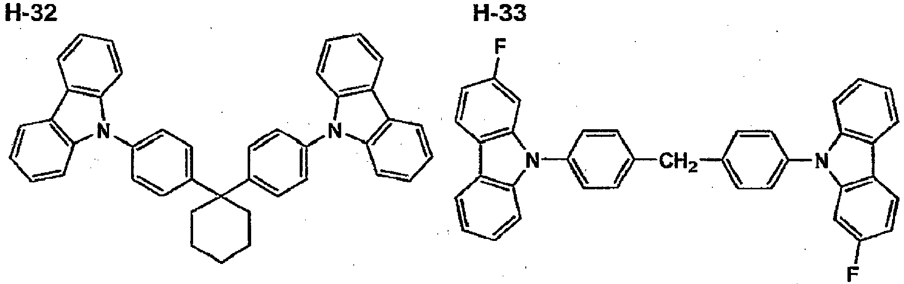

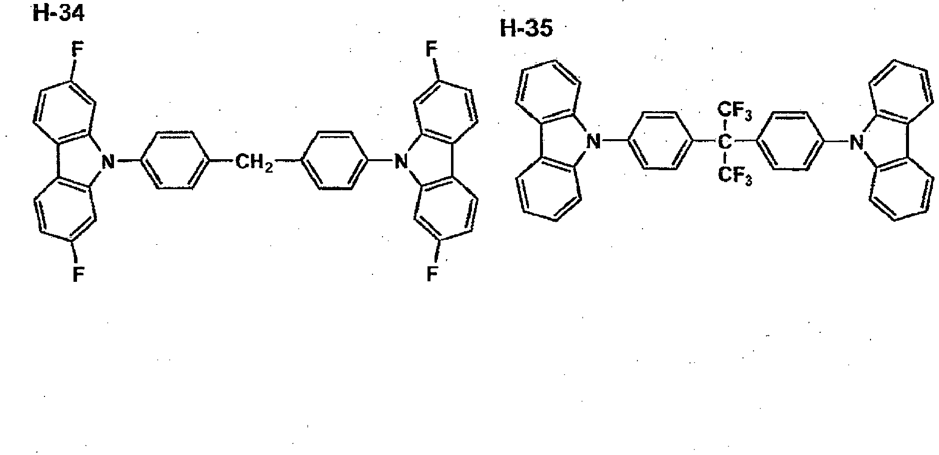

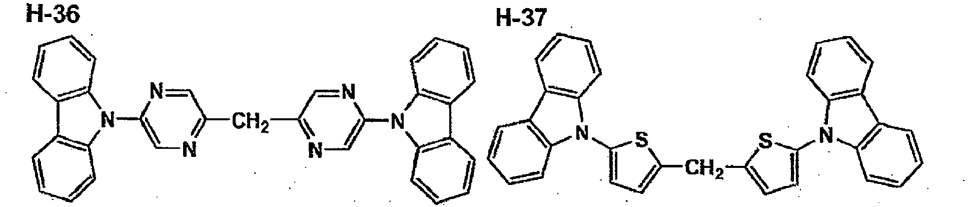

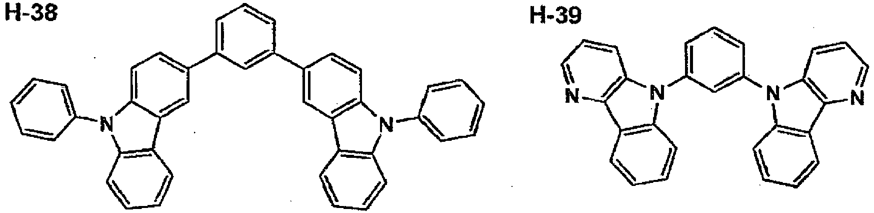

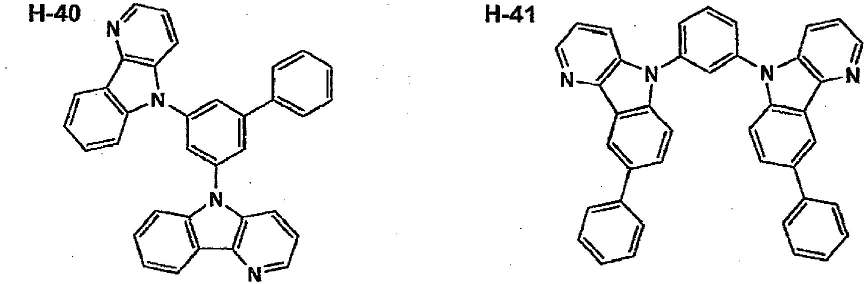

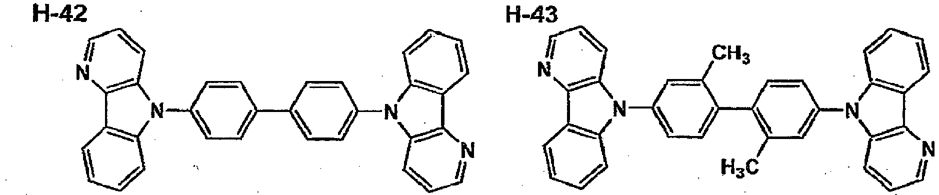

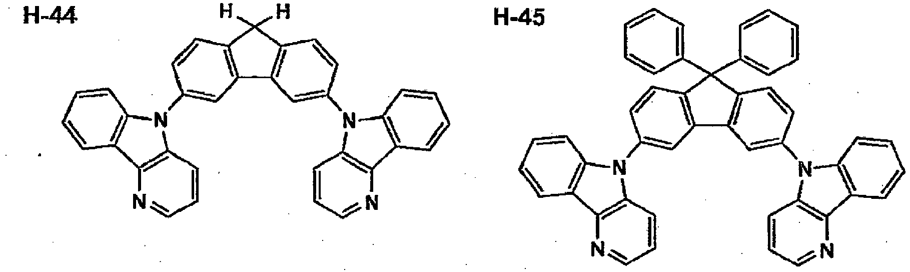

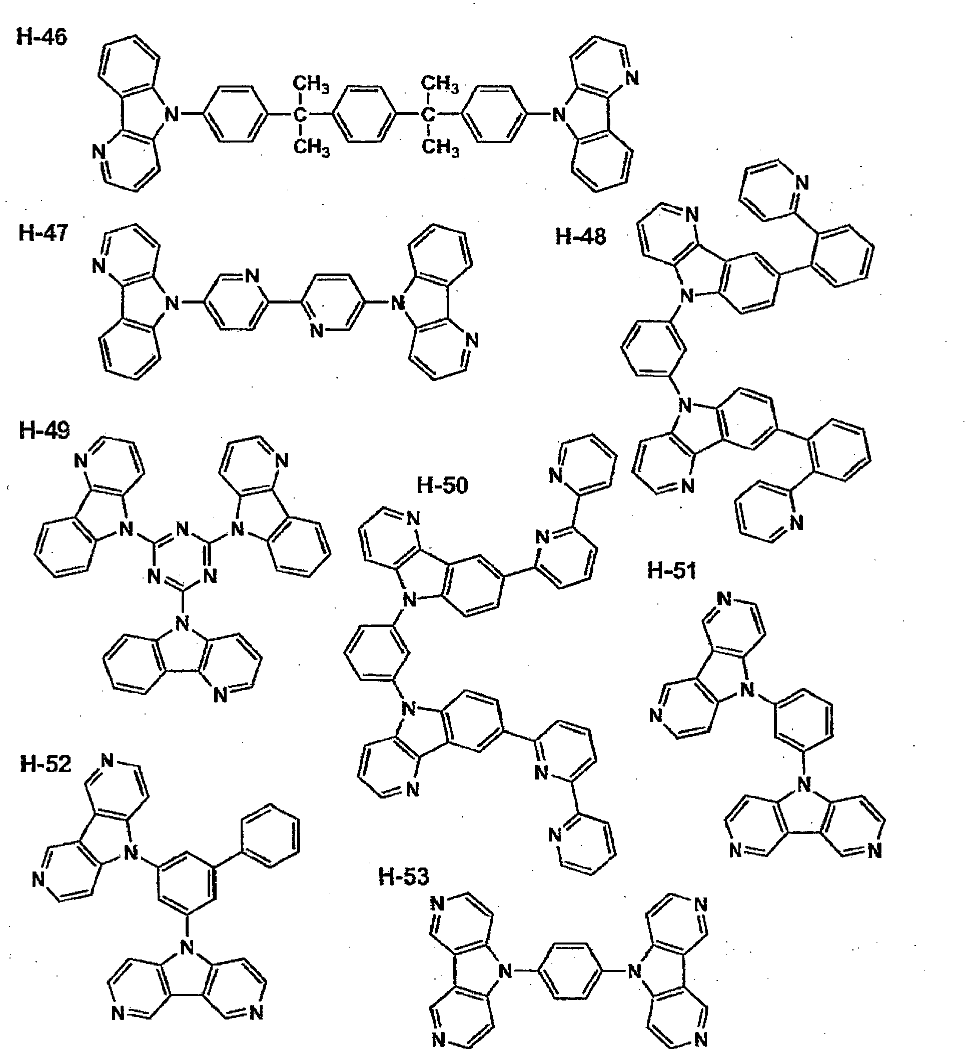

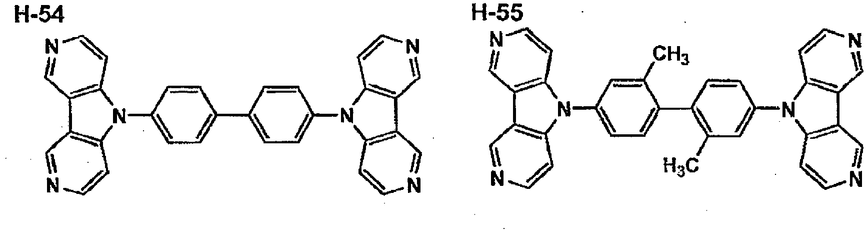

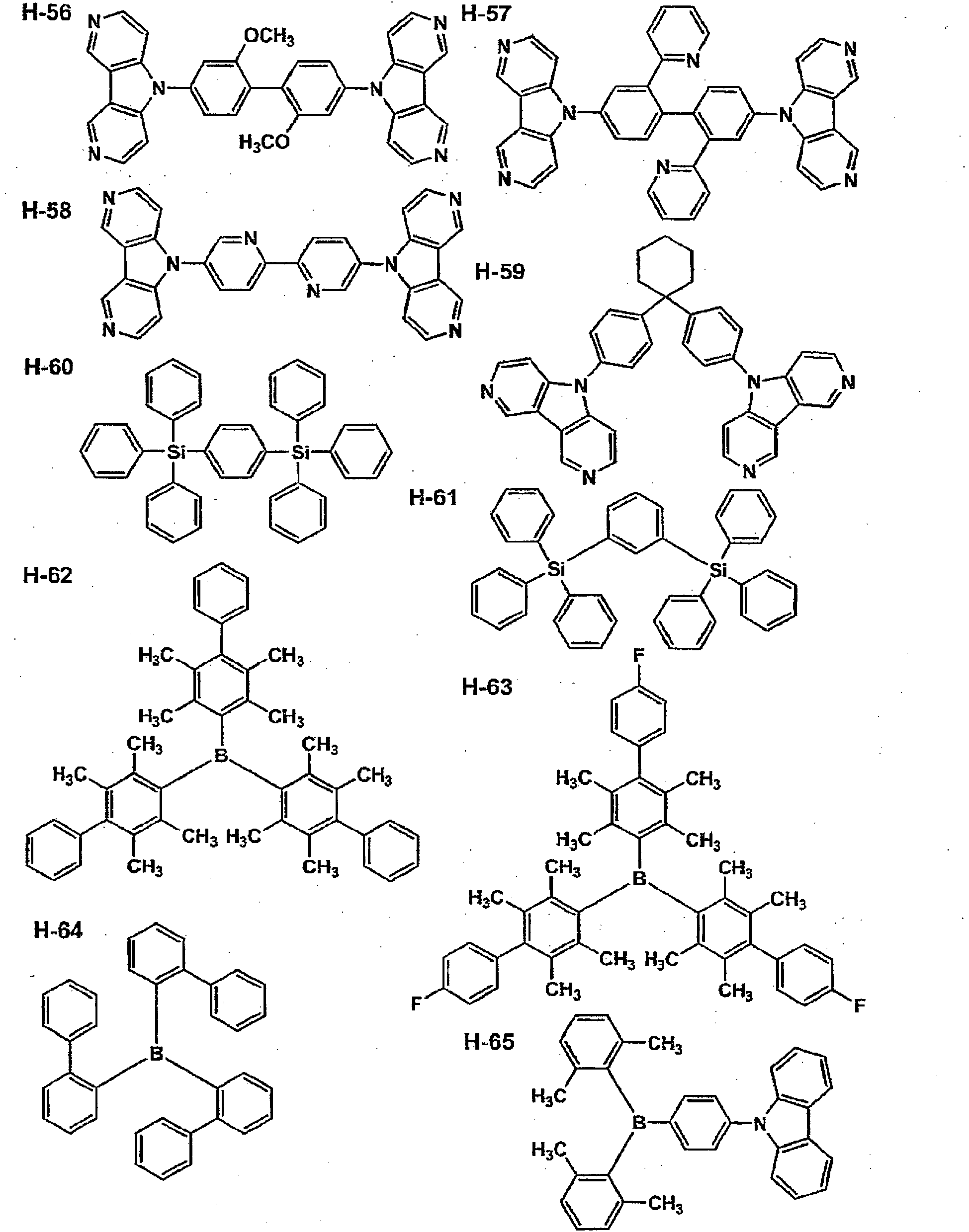

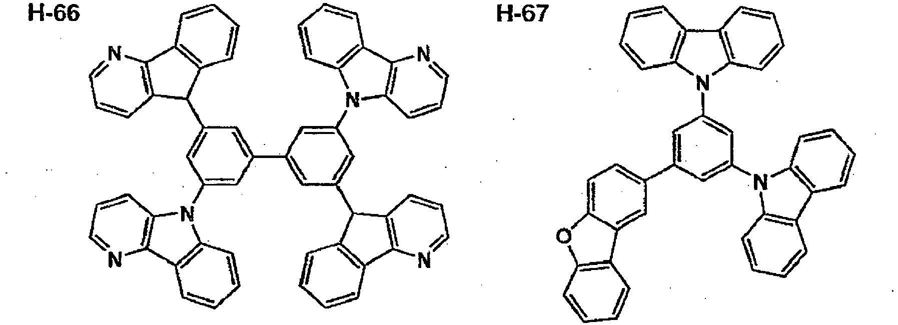

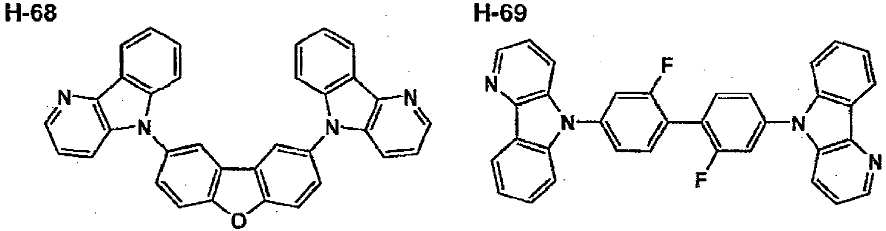

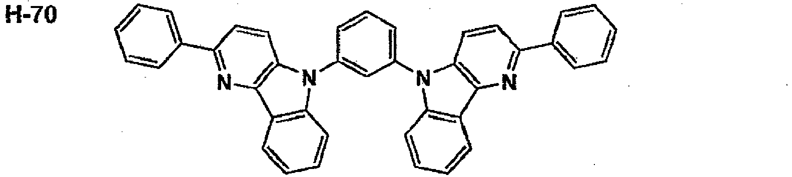

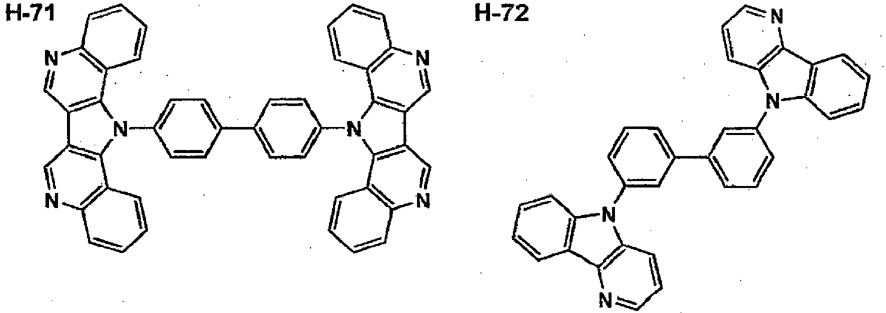

Next, representative structures of organic EL elements will be described.

### <Constituent Layers of Organic EL Element>

Typical constitutions of an organic EL element of the present invention will be described.

Specific examples of a preferable layer constitution of an organic EL element of this invention are shown below; however, the presnet invention is not limited thereto.
(i) anode/positive hole transport layer/emission layer/positive hole inhibition layer/electron transport layer/cathode,
(ii) anode/electron inhibition layer/emission layer/positive hole inhibition layer/electron transport layer/cathode,
(iii) anode/positive hole transport layer/electron inhibition layer/emission layer/positive hole inhibition layer/electron transport layer/cathode,
(iv) anode/anode buffer layer/positive hole transport layer/electron inhibition layer/emission layer/positive hole inhibition layer/electron transport layer/cathode,
(v) anode/positive hole transport layer/electron inhibition layer/emission layer/positive hole inhibition layer/electron transport layer/cathode buffer layer/cathode,
(vi) anode/anode buffer layer/positive hole transport layer/electron inhibition layer/emission layer/positive hole inhibition layer/electron transport layer/cathode buffer layer/cathode,
(vii) anode/anode buffer layer/positive hole transport layer/electron inhibition layer/emission layer/positive hole inhibition layer/electron transport layer/cathode buffer layer/cathode.
(viii) anode/positive hole transport layer/interlayer/ emission layer/positive hole inhibition layer/electron transport layer/cathode buffer layer/cathode.

Among the layer constitutions described above, the constitution (viii) relating to claims 1-7 is most preferable.

### <Interlayer>

An interlayer according to the present invention is a layer provided between an emission layer and a positive hole transport layer. The interlayer may be called as a positive hole transport layer or an electron inhibition layer depending on the property of the material included therein. In the present invention, it is preferably that the interlayer incorporates the same material as a host compound included in the emission layer.

### <Inhibition Layer (Electron Inhibition Layer, Positive Hole Inhibition Layer)>

An inhibition layer (such as an electron inhibition layer, a positive hole inhibition layer) according to this invention will now be explained.

The layer thickness of an inhibition layer according to this invention is preferably 3 - 100 nm and more preferably 5 - 30 nm.

### <Positive Hole Inhibition Layer>

A positive hole inhibition layer, in a broad meaning, is provided with a function of electron transport layer, being comprised of a material having a function of transporting an electron but a very small ability of transporting a positive hole, and can improve the recombination probability of an electron and a positive hole by inhibiting a positive hole while transporting an electron.

As a positive hole inhibition layer, for example, a positive inhibition layer described in such as JP-A Nos. 11-204258 and 11-204359 and p.273 of "Organic EL Elements and Idustrialization Front Thereof (Nov. 30 (1998), published by N. T. S Corp.)" is applicable to a positive hole inhibition (hole block) layer according to this invention. Further, a constitution of an electron transport layer described later can be appropriately utilized as a positive hole inhibition layer according to this invention.

It is preferable that the organic EL layer of the present invention incorporates a positive hole layer, which incorporates derivatives having a ring structure, in which at least one carbon atom of the hydrocarbon ring constituting the above carboline derivative or the carboline ring of the above carboline derivative is substituted with a nitrogen atom.

### <Electron Inhibition Layer>

On the other hand, an electron inhibition layer is, in a broad meaning, provided with a function of a positive hole transport layer, being comprised of a material having a function of transporting a positive hole but a very small ability of transporting an electron, and can improve the recombination probability of an electron and a positive hole by inhibiting an electron while transporting a positive hole. Further, a constitution of a positive hole transport layer described later can be appropriately utilized as an electron inhibition layer.

### <Positive Hole Transport Layer>

A positive hole transport layer contains a material having a function of transporting a positive hole, and in a broad meaning, a positive hole injection layer and an electron inhibition layer are also included in a positive hole transport layer. A single layer of or plural layers of a positive hole transport layer may be provided.

A positive hole transport material is not specifically limited and can be arbitrary selected from those such as generally utilized as a charge injection transporting material of a positive hole in a conventional photoconductive material and those which are well known in the art and utilized in a positive hole injection layer and a positive hole transport layer of an EL element.

A positive hole transport material is those having any one of a property to inject or transport a positive hole or a barrier property to an electron, and may be either an organic substance or an inorganic substance. For example, listed are a triazole derivative, an oxadiazole derivative, an imidazole derivative, a polyallylalkane derivative, a pyrazolone derivative, a phenylenediamine derivative, a allylamine derivative, an amino substituted chalcone derivative, an oxazole derivatives, a styrylanthracene derivative, a fluorenone derivative, a hydrazone derivative, a stilbene derivative, a silazane derivative, an aniline type copolymer, or conductive polymer oligomer and specifically preferably such as thiophene oligomer.

As a positive hole transport material, those described above can be utilized, however, it is preferable to utilized a porphyrin compound, an aromatic tertiary amine compound and a styrylamine compound, and specifically preferably an aromatic tertiary amine compound.

Typical examples of an aromatic tertiary amine compound and a styrylamine compound include N, N, N', N'-tetraphenyl-4, 4'-diaminophenyl; N, N'-diphenyl-N, N'-bis (3-methylpheriyl) - (1, 1'-biphenyl)-4, 4'-diamine (TPD); 2, 2-bist4-di-p-tolylaminophenyl)propane; 1, 1-bis(4-di-p-tolylaminophenyl)cyclohexane; N, N, N', N'-tetra-p-tolyl 4, 4'-diaminobiphenyl; 1, 1-bis(4-di-p-tolylaminophenyl)-4-phenylcyclohexane; bis(4-dimethylamino-2-metylphenyl)phenylmethane; bis(4-di-p-tolylaminophenyl)phenylmethane; N, N'-diphenyl-N, N'-di(4-methoxyphenyl)-4, 4'-diaminobiphenyl; N, N, N', N'-tetraphenyl-4, 4'-diaminophenylether; 4, 4' - bis(diphenylamino)quarterphenyl; N, N, N-tri (p-tolyl) amine; 4-(di-p-tolylamino)-4'-[4-(di-p-triamino)styryl]stilbene; 4-N,N-diphenylamino-(2-diphenylvinyl)benzene; 3-methoxy-4'-N, N-diphenylaminostilbenzene; and N-phenylcarbazole, in addition to those having two condensed aromatic rings in a molecule described in USP No. 5,061,569, such as 4, 4'-bis[N-(1-naphthyl)-N-phenylamino]biphenyl (NPD), and 4, 4', 4''-tris[N-(3-methylphenyl)-N-phenylamino]triphenylamine (MTDATA), in which three of triphenylamine units are bonded in a star burst form, described in JP-A 4-308688.

Polymer materials, in which these materials are introduced in a polymer chain or constitute the main chain of polymer, can be also utilized.

Further, an inorganic compound such as a p type-Si and a p type-SiC can be utilized as a positive hole injection material and a positive hole transport material

This positive hole transport layer can be prepared by forming a thin layer made of the above-described positive hole transport material according to a method well known in the art such as a vacuum evaporation method, a spin coating method, a cast method, an inkjet method and a LB method. The layer thickness of a positive hole transport layer is not specifically limited, however, is generally 5 - 5,000 nm. This positive transport layer may have a single layer structure comprised of one or not less than two types of the above described materials.

Further, an impurity-doped positive hole transport layer exhibiting high p-characteristics may be used. Examples thereof include those described in JP-A Nos. 4-297076, 2000-196140, and 2001-102175, as well as J. Appl. Phys., 95, 5773 (2004).

In the present invention, such a positive hole transport layer exhibiting high p-characteristics is preferably used to produce a low-power-consuming element.

### <Electron Transport Layer>

An electron transfer layer is composed of a material having a function to transfer an electron, and an electron injection layer and a positive hole inhibition layer are included in an electron transfer layer in a broad meaning. A single layer or plural layers of an electron transfer layer may be provided.

Further, an electron transfer layer is provided with a function to transmit an electron injected from a cathode to an emission layer, and compounds conventionally well known in the art can be utilized by arbitrarily selection as a material thereof.

Examples of a material utilized in this electron transfer layer (hereinafter, referred to as an electron transfer material) include such as a nitro-substituted fluorene derivative, a diphenylquinone derivative, a thiopyradineoxide derivative, a heterocyclic tetracarbonic acid anhydride such as naphthaleneperylene, carbodiimide, a fluorenylidenemethane derivative, anthraquinonedimethane and anthrone derivatives, and an oxadiazole derivative. Further, a thiazole derivative in which an oxygen atom in the oxadiazole ring of the above-described oxadiazole derivative is substituted by a sulfur atom, and a quinoxaline derivative having a quinoxaline ring which is known as an electron attracting group can be utilized as an electron transfer material.

Polymer materials, in which these materials are introduced in a polymer chain or these materials form the main chain of polymer, can be also utilized.

Further, a metal complex of a 8-quinolinol derivative such as tris(8-quinolinol)aluminum (Alq), tris(5,7-dichloro-8-quinolinol)aluminum, tris(5,7-dibromo-8-quinolinolyaluminum, tris(2-methyl-8-quinolinol)aluminum, tris(5-methyl-8-quinolinol)aluminum and bis(8-quinolinol)zinc (Znq); and metal complexes in which a central metal of the aforesaid metal complexes is substituted by In, Mg, Cu, Ca, Sn, Ga or Pb, can be also utilized as an electron transfer material. Further, metal-free or metal phthalocyanine, or those the terminal of which is substituted by an alkyl group and a sulfonic acid group, can be preferably utilized as an electron transfer material. Further, distyrylpyrazine derivative, which has been exemplified as a material of an emission layer, can be also utilized as an electron transfer material, and, similarly to the case of a positive hole injection layer and a positive hole transfer layer, an inorganic semiconductor such as an n-type-Si and an n-type-SiC can be also utilized as an electron transfer material.

This electron transport layer can be prepared by forming a thin layer made of the above-described electron transport material according to a method well known in the art such as a vacuum evaporation method, a spin coating method, a cast method, an inkjet method and a LB method. The layer thickness of an electron transport layer is not specifically limited; however, is generally 5 - 5,000 nm. This electron transport layer may have a single layer structure comprised of one or not less than two types of the above described materials.

### <Injection Layer>: Electron Injection Layer, Positive Hole Injection Layer

An injection layer is appropriately provided and includes an electron injection layer and a positive hole injection layer, which may be arranged between an anode and an emission layer or a positive transfer layer, and between a cathode and an emission layer or an electron transfer layer, as described above.

An injection layer is a layer which is arranged between an electrode and an organic layer to decrease an operating voltage and to improve an emission luminance, which is detailed in volume 2, chapter 2 (pp. 123 - 166) of "Organic EL Elements and Industrialization Front thereof (Nov. 30th 1998, published by N. T. S Corp.)", and includes a positive hole injection layer (an anode buffer layer) and an electron injection layer (a cathode buffer layer).

An anode buffer layer (a positive hole injection layer) is also detailed in such as JP-A 9-45479, 9-260062 and 8-288069, and specific examples include such as a phthalocyanine buffer layer comprising such as copper phthalocyanine, an oxide buffer layer comprising such as vanadium oxide, an amorphous carbon buffer layer, and a polymer buffer layer employing conductive polymer such as polythiophene.

A cathode buffer layer (an electron injection layer) is also detailed in such as JP-A 6-325871, 9-17574 and 10-74586, and specific examples include a metal buffer layer comprising such as strontium and aluminum, an alkali metal compound buffer layer comprising such as lithium fluoride, an alkali earth metal compound buffer layer comprising such as magnesium fluoride, and an oxide buffer layer comprising such as aluminum oxide.

The above-described buffer layer (injection layer) is preferably a very thin layer, and the layer thickness is preferably in a range of 0.1 - 100 nm although it depends on a raw material.

This injection layer can be prepared by forming a thin layer made of the above-described material according to a method well known in the art such as a vacuum evaporation method, a spin coating method, a cast method, an inkjet method and a LB method. The layer thickness of an injection layer is not specifically limited; however, is generally 5 - 5,000 nm. This injection layer may have a single layer structure comprised of one or not less than two types of the above described materials.

### <Anode>

As an anode according to an organic EL element of this invention, those comprising metal, alloy, a conductive compound, which is provided with a large work function (not less than 4 eV), and a mixture thereof as an electrode substance are preferably utilized. Specific examples of such an electrode substance include a conductive transparent material such as metal like Au, CuI, indium tin oxide (ITO), SnO₂ and ZnO. Further, a material such as IDIXO (In₂O₃-ZnO), which can prepare an amorphous and transparent electrode, may be also utilized. As for an anode, these electrode substances may be made into a thin layer by a method such as evaporation or spattering and a pattern of a desired form may be formed by means of photolithography, or in the case of requirement of pattern precision is not so severe (not less than 100 µm), a pattern may be formed through a mask of a desired form at the time of evaporation or spattering of the above-described substance. When emission is taken out of this anode, the transmittance is preferably set to not less than 10% and the sheet resistance as an anode is preferably not more than a few hundreds Ω/□. Further, although the layer thickness depends on a material, it is generally selected in a range of 10 - 1,000 nm and preferably of 10 - 200 nm.

### <Cathode>

On the other hand, as a cathode according to this invention, metal, alloy, a conductive compound and a mixture thereof, which have a small work function (not more than 4 eV), are utilized as an electrode substance. Specific examples of such an electrode substance includes such as sodium, sodium-potassium alloy, magnesium, lithium, a magnesium/copper mixture, a magnesium/silver mixture, a magnesium/aluminum mixture, a magnesium/indium mixture, an aluminum/aluminum oxide (Al₂O₃) mixture, indium, a lithium/aluminum mixture and rare earth metal. Among them, with respect to an electron injection property and durability against such as oxidation, preferable are a mixture of electron injecting metal with the second metal which is stable metal having a work function larger than electron injecting metal, such as a magnesium/silver mixture, a magnesium/aluminum mixture, a magnesium/indium mixture, an aluminum/aluminum oxide (Al₂O₃) mixture and a lithium/aluminum mixture, and aluminum. As for a cathode, these electrode substances may be made into a thin layer by a method such as evaporation or spattering. Further, the sheet resistance as a cathode is preferably not more than a few hundreds Ω/□ and the layer thickness is generally selected in a range of 10 - 1,000 nm and preferably of 50 - 200 nm. Herein, to transmit emission, either one of an anode or a cathode of an organic EL element is preferably transparent or translucent to improve the mission luminance.

### <Substrate (also referred to as Base Plate, Base Material or Support)>

A substrate according to an organic EL element of this invention is not specifically limited with respect to types of such as glass and plastics provided being transparent, however, a substrate preferably utilized includes such as glass, quartz and transparent resin film. A specifically preferable substrate is resin film capable of providing an organic EL element with a flexible property.

Resin film includes such as film comprised of polyethylene terephthalate (PET), polyethylene naphthalate (PEN), polyether sulphone (PES), polyether imide, polyether etherketone, polyphenylene sulfide, polyallylate, polyimide, polycarbonate (PC), cellulose triacetate (TAC) and cellulose acetate propionate (CAP).

On the surface of resin film, an inorganic or organic cover layer or a hybrid cover layer comprising the both may be formed, and the film is preferably provided with a high barrier ability having a vapor transmittance of not more than 0.01 g/m²·day·at atm.

The taking out efficiency of emission of an organic EL element of this invention at room temperature is preferably not less than 1% and more preferably not less than 2%. Herein, taking out quantum efficiency (%) = photon number emitted out of organic EL element/electron number flown into organic EL element x 100.

In the case of an illumination application, roughening processed film (such as anti-glare film) can be also utilized in combination to decrease emission unevenness.

Further, a hue improving filter such as a color filter may be utilized in combination.

In the case of an application as a multi-color display device, the display is comprised of at least two types of organic EL elements having different emission maximum wavelengths, and a preferable example to prepare an organic EL element will now be explained.

### <Preparation Method of Organic EL Element>

As an example of a preparation method of an organic EL element described in claims 1 - 7 of the present invention, a preparation method of an organic EL element, comprising anode/positive hole injection layer/positive hole transport layer/emission layer/positive hole inhibition layer/electron transport layer/cathode buffer layer/cathode, will be explained.

First, on an appropriate substrate, a thin layer comprising a desired electrode substance such as an anode electrode substance is formed by means of evaporation or spattering so as to make a layer thickness of not more than 1 µm and preferably of 10 - 200 nm, whereby an anode is prepared. Next, on this layer, thin layers containing organic substances of such as a positive hole injection layer, a positive hole transport layer, an emission layer, a positive hole inhibition layer and an electron transport layer are formed.

A thin layer forming method of these layers containing the organic substances includes such as a spin coat method, a cast method, an inkjet method, an evaporation method and a printing method as described before, however, a vacuum evaporation method or a spin coat method is specifically preferable with respect to easy preparation of a homogeneous layer and bare generation of pinholes. Further, a different layer forming method depending on each layer may be applied. In the case of employing an evaporation method in layer formation, the evaporation condition depends on such as the type of a utilized compound, however, is generally appropriately selected in a range of 50 - 450 °C as a boat heating temperature, 10⁻⁶ - 10⁻² Pa as a vacuum degree, 0.01 - 50 nm/sec as a deposition rate, -50 - 300 °C as a substrate temperature and 1 nm - 5 µm as a layer thickness.

After formation of these layers, a thin layer comprising a cathode electrode substance is formed thereon by means of such as evaporation or spattering so as to make a layer thickness of less than 1 µm or preferably in a range of 50 - 200 nm to provide a cathode, whereby a desired organic EL element can be prepared. This preparation of an organic EL element is preferably carried out with one time evacuation to prepare all through from a positive hole injection layer to a cathode, however, different layer forming method may be also applied by taking out the element on the way. At that time, it is preferable to take consideration such as to perform the operation under a dry inert gas environment.

### <Display Device>

A display device described in claims 5 and 7 of this invention will now be explained. The display device of this invention includes the above-described organic EL element.

A display device of this invention may be either monochromatic or multi-colored. Here explained will be a multicolor display device. In the case of a multicolor display device, a shadow mask is provided only at the time of emission layer formation, and layers can be formed all over the surface by such as an evaporation method, a cast method, a spin coat method, an inkjet method and a printing method.

When patterning is performed only with an emission layer, the method is not specifically limited; however, preferable are an evaporation method, an inkjet method and a printing method. And patterning employing a shadow mask is preferred in the case of an evaporation method. Further, reversing the preparation order, it is also possible to prepare layers in the order of a cathode, an electron transport layer, a positive hole inhibition layer, an emission layer, a positive hole transport layer and an anode.

When a direct current voltage is applied on the multicolor display device thus prepared, emission can be observed by application of a voltage of approximately 2 - 40 V setting an anode to + polarity and a cathode to - polarity. Further, no current flows and no,emission generate at all even when a voltage is applied with a reversed polarity. Further, in the case of alternate current voltage being applied, emission generates only in a state of an anode being + and a cathode being -. Herein, the wave shape of alternate current may be arbitrary.

A multicolor display device can be utilized as a display device, a display and various types of emission light sources. In a display device and a display, full-colored display is possible by employing three types of organic EL elements providing blue, red and green emissions. A display device and a display include a TV, a personal computer, a mobile instrument, an AV instrument, a character broadcast display and an information display in a car. Particularly, the display device and the display may be also utilized as a display to playback still images and moving images, and may adopt either a simple matrix (a passive matrix) mode or an active matrix mode when being utilized as a display device for moving image playback.

An illumination light source includes a home use illumination, a car room illumination, a backlight of a watch or a liquid crystal, a panel advertisement, a signal, a light source of an optical memory medium, a light source for an electrophotographic copier, a light source for an optical telecommunication processor and a light source for a photosensor, however, is not limited thereto.

### <Illumination Device>

An illumination device of this invention will now be explained. The illumination device of this invention includes the above-described organic EL element.

An organic EL element of this invention can be utilized as an organic EL element provided with a resonator structure, and a utilization purpose of such an organic EL element provided with a resonator structure includes such as a light source for an optical memory medium, a light source for an electrophotographic copier, a light source for a optical telecommunication processor and a light source for a photosensor, however, is not limited thereto. Further, the organic EL element may be utilized for the above-described applications by being made to perform laser emission.

Further, an organic EL element of this invention may be utilized as one type of a lamp like an illumination and an exposure light, and may be also utilized as a display device of a projector of an image projecting type and a display device (a display) of a type to directly view still images and moving images. An operating mode in the case of being utilized as a display device for playback of moving images may be either a simple matrix (a passive matrix) mode or an active matrix mode. In addition, a full-color display device can be prepared by utilizing at least two types of organic EL elements of this invention which emit different emitting colors.

When an organic EL element of this invention is used as a white color emission element, a full-color image display can be realized by combining BGR color filters.

An organic EL element of this invention can be applied to an illumination device emitting substantially a white color.

In the following, one example of a display device provided with an organic EL element of this invention will be explained.

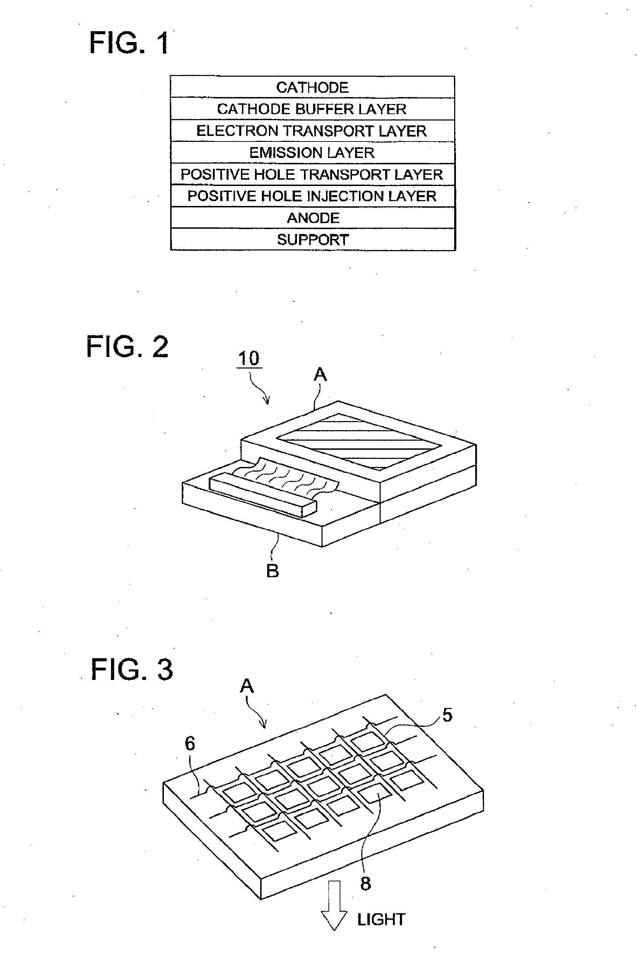

Fig. 2 is a schematic drawing to show an example of a display device constituted of an organic EL element. It is a schematic drawing of a display, which displays image information by emission of an organic EL element, such as a mobile phone. Display 1 is constituted of such as display section A having plural number of pixels and control section B which performs image scanning of display section A based on image information. Control section B, which is electrically connected to display section A, sends a scanning signal and an image data signal to plural number of pixels based on image information from the outside and pixels of each scanning line successively emit depending on the image data signal by a scanning signal to perform image scanning, whereby image information is displayed on display section A.

Fig. 3 is a schematic drawing of display section A. Display section A is provided with such as a wiring part, which contains plural scanning lines 5 and data lines 6, and plural pixels 3 on a substrate. Primary part materials of display section A will be explained in the following. In the drawing, shown is the case that light emitted by pixel 3 is taken out along the white allow (downward). Scanning lines 5 and plural data lines 6 in a wiring part each are comprised of a conductive material, and scanning lines 5 and data lines 6 are perpendicular in a grid form and are connected to pixels 3 at the right-angled crossing points (details are not shown in the drawing). Pixel 3 receives an image data from data line 6 when a scanning signal is applied from scanning line 5 and emits according to the received image data. Full-color display device is possible by appropriately arranging pixels having an emission color in a red region, pixels in a green region and pixels in a blue region, side by side on the same substrate.

Next, an emission process of a pixel will be explained.

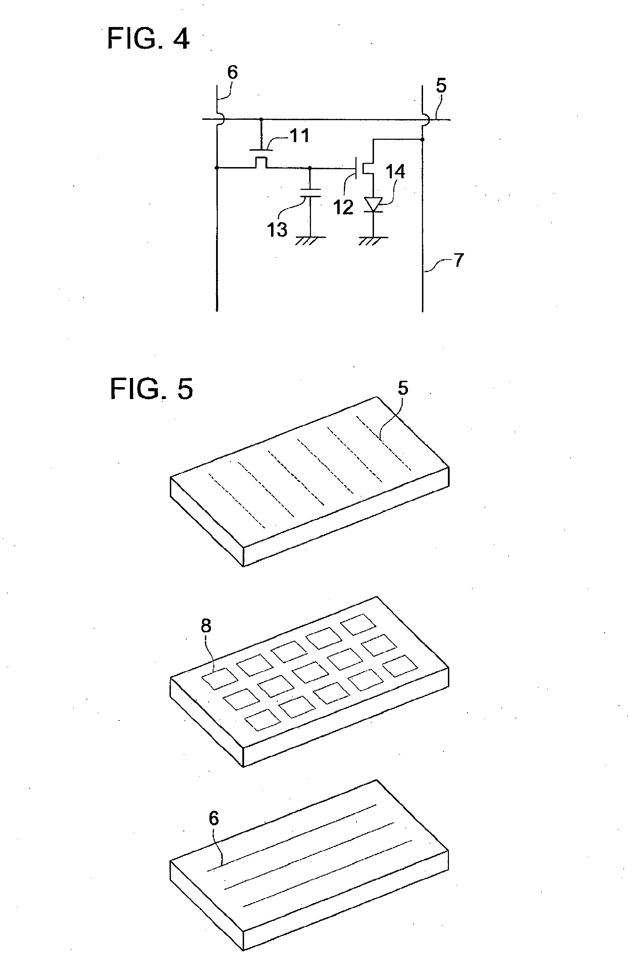

Fig. 4 is a schematic drawing of a pixel. A pixel is equipped with such as organic EL element 10, switching transistor 11, operating transistor 12 and capacitor 13. Red, green and blue emitting organic EL elements are utilized as organic EL element 10 for plural pixels, and full-color display device is possible by arranging these side by side on the same substrate.

In Fig. 4, an image data signal is applied on the drain of switching transistor 11 via data line 6 from control section B. Then, when a scanning signal is applied on the gate of switching transistor 11 via scanning line 5 from control section B, operation of switching transistor is on to transmit the image data signal applied on the drain to the gates of capacitor 13 and operating transistor 12. Operating transistor 12 is on, simultaneously with capacitor 13 being charged depending on the potential of an image data signal, by transmission of an image data signal. In operating transistor 12, the drain is connected to electric source line 7 and the source is connected to the electrode of organic EL element 10, and an electric current is supplied from electric source line 7 to organic EL element 10 depending on the potential of an image data applied on the gate. When a scanning signal is transferred to next scanning line 5 by successive scanning of control section B, operation of switching transistor 11 is off. However, since capacitor 13 keeps the charged potential of an image data signal even when operation of switching transistor 11 is off, operation of operating transistor 12 is kept on to continue emission of organic EL element 10 until the next scanning signal is applied. When the next scanning signal is applied by successive scanning, operating transistor 12 operates depending on the potential of an image data signal synchronized to the scanning signal and organic EL element 10 emits.

That is, emission of each organic EL element 10 of plural pixels 3 is performed by providing switching transistor 11 and operating transistor 12 against each organic EL element 10 of plural pixels 3. Such an emission method is called as an active matrix mode. Herein, emission of organic EL element 10 may be either emission of plural gradations based on a multiple-valued image data signal having plural number of gradation potentials or on and off of a predetermined emission quantity based on a binary image data signal. Further, potential hold of capacitor 13 may be either continuously maintained until the next scanning signal application or discharged immediately before the next scanning signal application.

In this invention, emission operation is not necessarily limited to the above-described active matrix mode but may be a passive matrix mode in which organic EL element is emitted based on a data signal only when a scanning signal is scanned.

Fig. 5 is a schematic drawing of a display device based on a passive matrix mode. In Fig. 5, plural number of scanning lines 5 and plural number of image data lines 6 are arranged grid-wise, opposing to each other and sandwiching pixels 3.

When a scanning signal of scanning line 5 is applied by successive scanning, pixel 3 connected to scanning line 5 applied with said signal emits depending on an image data signal. Since pixel 3 is provided with no active element in a passive matrix mode, decrease of manufacturing cost is possible.

An organic EL element material described in claims 1 - 7 of this invention can be also applied to an organic EL element to generate emission of practically white color as an illumination device. Plural emission colors are simultaneously emitted by plural number of emission materials to obtain white light by mixing colors. A combination of plural emission colors may be either the one, in which three emission maximum wavelengths of three primary colors of blue, green and red are contained, or the other, in which two emission maximum wavelengths, utilizing a relationship of complimentary colors such as blue and yellow, or blue and orange, are contained.

Further, a combination of emission materials to obtain plural number of emission colors may be either a combination comprising plural number of materials which emit phosphoresce or fluorescence, or a combination of a material which emits phosphoresce or fluorescence and a dye material which emits by light from an emission material as exiting light, however, in a white organic electroluminescent element according to this invention, it is enough only to mix plural emission dopants in combination. A mask is provided only at the time of forming such as an emission layer, a positive hole transport layer or an electron transport layer, to only simply arrange the plural emission dopants such as by separately painting through the mask, while other layers are commonly utilized to require no patterning such as a mask. Therefore, such as an electrode can be formed all over the plane by such as an evaporation method, a cast method, a spin coat method, an inkjet method and a printing method, resulting in improvement of productivity. According to this method, different from a white organic EL device in which plural colors of emission elements are arranged parallel in an alley form, an element itself is white emitting.

An emission material utilized in an emission layer is not specifically limited, and in the case of a backlight of a liquid crystal display element, any combination by arbitrary selection among platinum complexes according to this invention or emission materials well known in the art can be utilized so as to be fitted to the wavelength range corresponding to CF (color filter) characteristics, whereby white emission can be obtained.

In this manner, a white emitting organic EL element having a structure of claims 1 - 7 of this invention is usefully utilized as one type of a lamp such as a home use illumination, a car room illumination or an exposure light source as various emission light sources or illumination devices, in addition to the aforesaid display device and a display, and is further usefully applied for a display as such as a backlight of a liquid crystal display.

In addition to these, listed is a wide range of applications such as a backlight of a watch, an advertising board, a signal, a light source of an optical memory medium, a light source of an electrophotographic copier, a light source of an optical telecommunication processor and a light source of an optical sensor, and further general home use electric instruments which require a display device.

### EXAMPLES

In the following, this invention will be explained with reference to examples, however, this invention is not limited thereto. The compounds used in examples are shown below.

### Example 1

### <Calculation of a HOMO level and a LUMO level of the materials>

In the present invention, the values of the HOMO and the LUMO levels were calculated for the materials indicated below. These values were obtained by calculations using Gaussian 98 (Gaussian 98, Revision A. 11. 4, M.J.Frisch, et al, Gaussian, Inc.., Pittsburg PA, 2002), which is a software for a molecular orbital calculation, and produced by Gaussian Inc., and are defined as values (a converted value in eV unit). For host compounds, the HOMO and the LUMO levels were calculated via structure optimization employing B3LYP/6-31G*. And for phosphorescent compounds, the HOMO and the LUMO levels were calculated via structure optimization employing B3LYP/LanL2DZ as a key word. The calculated values are shown below.

**Table 2**

| | Name of compound | of HOMO (eV) | LUMO(eV) |
|---|---|---|---|
| Phosphorescent compound | Fir(pic) | -5.99 | -2.36 |
| | EXD-1 | -4.70 | -0.67 |
| | 1-18 | -5.13 | -0.97 |
| | 1-20 | -5.02 | -1.20 |
| | 1-1 | -4.37 | -0.57 |
| | 1-2 | -4.53 | -0.76 |
| | 1-5 | -4.18 | -0.42 |
| | 1-58 | -4.34 | -0.55 |
| | 1-90 | -4.26 | -0.47 |
| | 1-99 | -4.36 | -0.66 |
| Host compound H-35 | CBP | -5.31 | -1.22 |
| | H-7 | -5.78 | -0.99 |
| | H-21 | -5.83 | -1.48 |
| | H-22 | -5.91 | -1.68 |
| | H-23 | -5.68 | -1.51 |
| | H-25 | -5.66 | -1.55 |
| | H-28 | -5.45 | -1.18 |
| | H-35 | -5.50 | 0.95 |
| | H-38 | -5.91 | -0.93 |
| | H-39 | -5.73 | -1.16 |
| | H-55 | -6.31 | -1.21 |
| | H-61 | -6.52 | -0.59 |
| | H-62 | -5.83 | -1.43 |
| | H-67 | -5.45 | -1.17 |
| | H-68 | -5.62 | -1.61 |
| | H-70 | -5.53 | -1.24 |

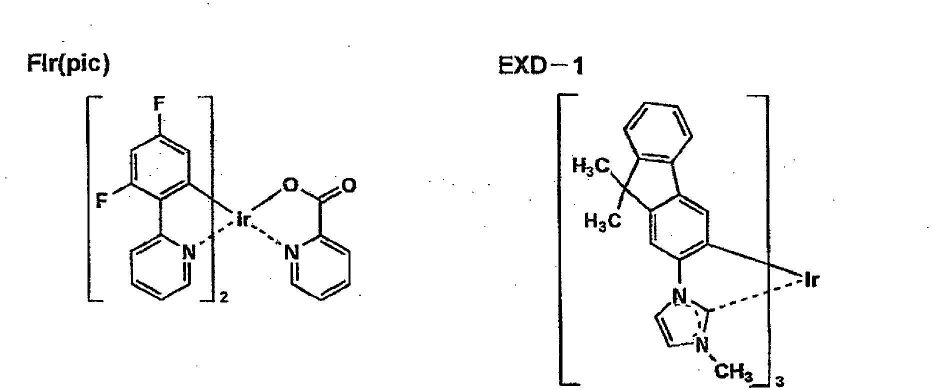

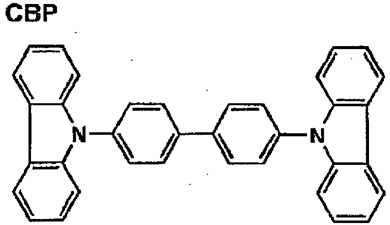

### <Preparation of Organic EL Element 1-1, which is not according to the present invention>

After a substrate, in which ITO had been deposited at 150 nm on a glass plate as an anode (NA-45 produced by NH Techno Glass Co. Ltd.) was subjected to patterning, the transparent support substrate was washed with isopropyl alcohol by use of ultrasonic waves, followed by being dried with a dry nitrogen gas, and was subjected to UV ozone washing for 5 minutes. This transparent support substrate was fixed on a substrate holder of a vacuum evaporation system available on the market, and at the same time, each of five resistance heating boats made of tantalum was charged with α-NPD, CBP, Fir(pic), BC and Alq₃, respectively, which was attached in the vacuum evaporation system (in the first vacuum chamber). Further, a resistance heating boat made of tantalum was charged with lithium fluoride and a resistance heating boat made of tungsten was charged with aluminum, respectively, and these boats were attached in the second chamber of the vacuum evaporation system.

First, after the first vacuum chamber was evacuated down to 4 x 10⁻⁴ Pa, the aforesaid heating boat charged with α-NPD was heated with an electric current to deposit α-NPD on a transparent support substrate at a deposition rate of 0.1 - 0.2 nm/sec so as to make a layer thickness of 90 nm, whereby a positive hole injection/transport layer was formed.

Further, the aforesaid heating boat charged with CBP and the boat charged with Fir(pic) were independently supplied with an electric current to deposit CBP as an emission host and Fir(pic) as an phosphorescent compound so as to make a layer thickness of 30 nm while adjusting the deposition rates thereof to 100 : 6, whereby an emission layer was formed.

Next, the aforesaid heating boat charged with BC was heated with an electric current to provide a positive hole inhibition layer having a layer thickness of 10 nm at a deposition rate of 0.1 - 0.2 nm/sec.

Further, the aforesaid heating boat charged with Alq₃ was heated with an electric current to provide an electron transport layer having a layer thickness of 20 nm at a deposition rate of 0.1 - 0.2 nm/sec.

Next, after an element having been deposited with up to an electron injection layer as described before was transferred into the second vacuum chamber while keeping vacuum, a mask, which was made of stainless steel and had rectangular holes, was arranged on the electron injection layer by means of remote control from outside of the system. After the second vacuum chamber was evacuated down to 2 x 10⁻⁴Pa, a boat charged with lithium fluoride was supplied with an electric current to provide a cathode buffer layer having a layer thickness of 0.5 nm at a deposition rate of 0.01-0.02 nm/sec, and then a boat charged with aluminum was supplied with an electric current to provide a cathode having a layer thickness of 150 nm at a deposition rate of 1 - 2 nm/sec to obtain Organic EL Element 1-1.

### <Preparation of Organic EL Elements 1-2 - 1-19, from which only Organic EL element 1-13 is according to the present invention>

Organic EL elements 1-2 - 1-19 each were prepared in a similar manner to preparation of organic EL element 1-1 described above, except that an emission dopant was changed as shown in table 2.

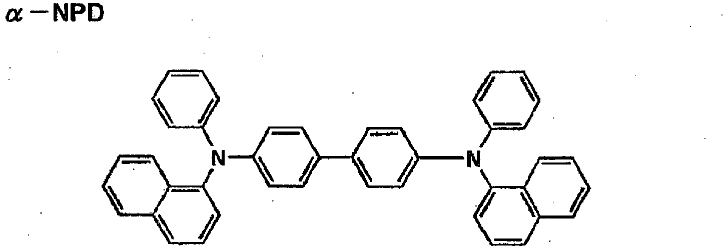

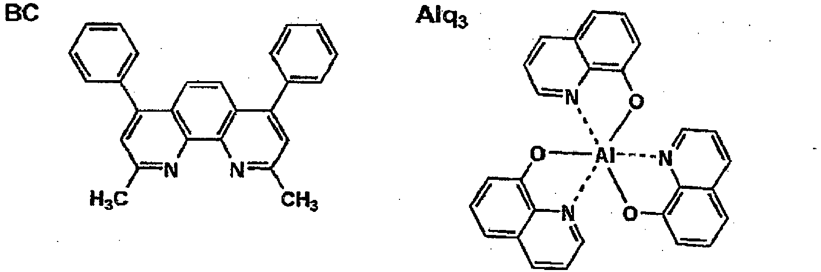

### <Evaluation of Organic EL Elements>

Organic EL elements 1-1 - 1-19 thus obtained were subjected to measure a voltage required to attain a luminance of 1000 cd/m² at room temperature. The driving voltages are shown as relative values when the determined value of Organic EL Element 1-1 is designated as 100. The obtained results are shown in Table 3.

**Table 3**

| | Host compound | Phosphorescent compound | Driving voltage (relative value) | Remarks |
|---|---|---|---|---|
| Organic EL elements 1-1 | CBP | Fir(pic) | 100 | Comparative |
| Organic EL elements 1-2 | H-28 | Fir(pic) | 95 | Comparative |
| Organic EL elements 1-3 | H-35 | exd-1 | 88 | Comparative |
| Organic EL elements 1-4 | H-61 | exd-1 | 89 | Comparative |
| Organic EL elements 1-5 | CBP | 1-18 | 105 | Comparative |
| Organic EL elements 1-6 | CBP | 1-1 | 98 | Comparative |
| Organic EL elements 1-7 | H-7 | 1-20 | 75 | Comparative |
| Organic EL elements 1-8 | H-7 | 1-2 | 62 | Comparative |
| Organic EL elements 1-9 | H-21 | 1-5 | 52 | Comparative |
| Organic EL elements 1-10 | H-22 | 1-1 | 49 | Comparative |
| Organic EL elements 1-11 | H-23 | 1-20 | 58 | Comparative |
| Organic EL elements 1-12 | H-25 | 1-2 | 51 | Comparative |
| Organic EL elements 1-13 | H-39 | 1-58 | 45 | Present invention |
| Organic EL elements 1-14 | H-35 | 1-1 | 52 | Comparative |
| Organic EL elements 1-15 | H-38 | 1-20 | 63 | Comparative |
| Organic EL elements 1-16 | H-39 | 1-5 | 47 | Comparative |
| Organic EL elements 1-17 | H-55 | 1-2 | 49 | Comparative |
| Organic EL elements 1-18 | H-61 | 1-2 | 50 | Comparative |
| Organic EL elements 1-19 | H-62 | 1-1 | 52 | Comparative |

It is clear from Table 3 that Organic EL element 1-13 containing a combination of a host compound provided with HOMO and LUMO levels set out by the present invention and a phosphorescent compound according to the present invention enable to achieve a lower driving voltage compared with Comparative samples.

### <Preparation of Organic EL Element 1-20, which is not according to the present invention>

After a substrate, in which ITO had been deposited at 150 nm on a glass plate as an anode (NA-45 produced by NH Techno Glass Co. Ltd.) was subjected to patterning, the transparent support substrate was washed with isopropyl alcohol by use of ultrasonic waves, followed by being dried with a dry nitrogen gas. A solution prepared by diluting poly(3,4-ethylenedioxythiophene)-palystyrenesulfonate (PEDOT/PSS, produced by Bayer Co., BASYTRON P A1 4083) with pure water to 70% by weight was applied to the resulting transparent substrate at 3,000 rpm over 30 seconds, employing a spin coating method, and subsequently dried at 200 °C over 1 hour, whereby a 30 nm thick positive hole injection transport layer was resulted. Then, this transparent support substrate was fixed on a substrate holder of a vacuum evaporation system available on the market.

At the same time, each of five resistance heating boats made of tantalum was charged with α-NPD, H-28, FIr6, BAlq and Alq₃, respectively, which was attached in the vacuum evaporation system (in the first vacuum chamber). Further, two resistance heating boats made of tungsten were charged with magnesium (Mg) and silver (Ag), respectively, and these boats were attached in the second chamber of the vacuum evaporation system.

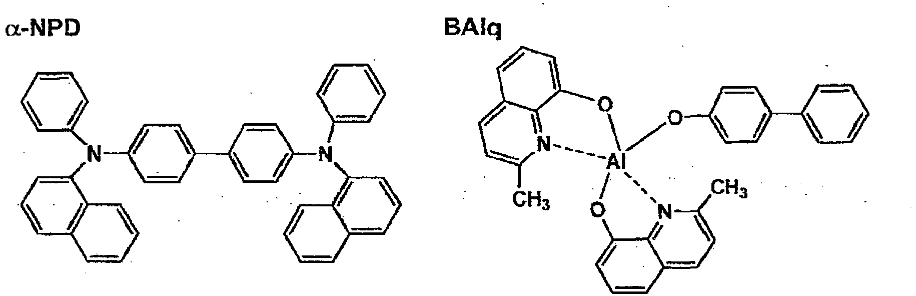

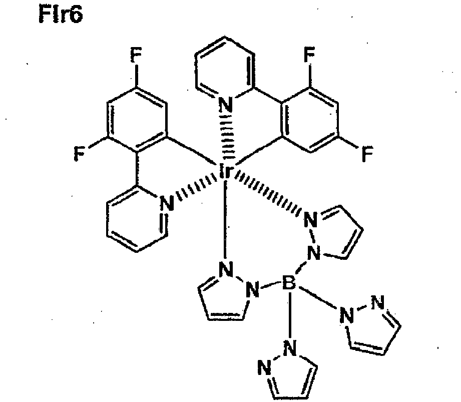

First, after the first vacuum chamber was evacuated down to 4 x 10⁻⁴ Pa, the aforesaid heating boat charged with α-NPD was heated with an electric current to deposit α-NPD on a support substrate at a deposition rate of 0.1 -0.2 nm/sec so as to make a layer thickness of 90 nm, whereby a positive hole injection/transport layer was formed.

Further, the aforesaid heating boat charged with H-28 and the boat charged with Fir6 were independently supplied with an electric current to deposit H-28 as an emission host and Fir6 as a phosphorescent compound so as to make a layer thickness of 30 nm while adjusting the deposition rates thereof to 100 : 6, whereby an emission layer was formed.

Next, the aforesaid heating boat charged with BAlq was heated with an electric current to provide a positive hole inhibition layer having a layer thickness of 10 nm at a deposition rate of 0.1 - 0.2 nm/sec. Further, the aforesaid heating boat charged with Alq₃ was heated with an electric current to provide an electron transport layer having a layer thickness of 30 nm at a deposition rate of 0.1 - 0.2 nm/sec.

Next, after an element having been deposited with up to an electron injection layer as described before was transferred into the second vacuum chamber while keeping vacuum, a mask, which was made of stainless steel and had rectangular holes, was arranged on the electron injection layer by means of remote control from outside of the system. After the second vacuum chamber was evacuated down to 2 x 10⁻⁴Pa, the boat charged with Mg and the boat charged with Ag were supplied with an electric current to provide a cathode of MgAg (10 : 1) having a layer thickness of 150 nm to obtain Organic EL Element 1-20.

### <Preparation of Organic EL Elements 1-21 - 1-27

Organic EL elements 1-21 - 1-27 each were prepared in a similar manner to preparation of organic EL element 1-20 described above, except that a host compound and a phosphorescent compound were changed as shown in Table 4.

### <Evaluation of Organic EL Elements>

Organic EL elements 1-20 - 1-27 thus obtained were subjected to measure a voltage required to attain a luminance of 1500 cd/m² at room temperature. The driving voltages are relative values when the determined values of Organic EL Element 1-20 is designated as 100. The obtained results are shown in Table 4.

**Table 4**

| | Host compound | Phosphorescent compound | Driving voltage (relative value) | Remarks |
|---|---|---|---|---|
| Organic EL elements 1-20 | H-28 | FIr6 | 100 | Comparative |
| Organic EL elements 1-21 | CBP | 1-90 | 88 | Comparative |
| Organic EL elements 1-22 | H-70 | 1-58 | 67 | Present invention |
| Organic EL elements 1-23 | H-67 | 1-58 | 45 | Present invention |
| Organic EL elements 1-24 | H-68 | 1-58 | 40 | Present invention |
| Organic EL elements 1-25 | H-70 | 1-90 | 65 | Present invention |
| Organic EL elements 1-26 | H-67 | 1-90 | 48 | Present invention |
| Organic EL elements 1-27 | H-68 | 1-90 | 44 | Present invention |
| Organic EL elements 1-28 | H-67 | 1-99 | 47 | Present invention |

It has been proved that Organic EL elements of the present invention exhibited a low driving voltage and they are preferable.

### Example 2 (Invention having a constitution described in the claims 1 - 7)

### <Preparation of Full-color Display Device>

### (Preparation of Blue Emission Element)

Organic EL element 1-10 of example 1, which is not according to the present invention was utilized as a blue emission element.

### (Preparation of Green Emission Element)

A green emission element which is not according to the present invention was prepared in the same method as preparing Organic EL element 1-10 except that a host compound and a dopant used in Organic EL element 1-10 were substituted with CBP and Ir(ppy)₃, respectively.

### (Preparation of Red Emission Element)

A red emission element which is not according to the present invention was prepared in the same method as preparing Organic EL element 1-10 except that a host compound and a dopant used in Organic EL element 1-10 were substituted with CBP and Ir(btpy)₃, respectively.

Each of red, green and blue organic EL elements prepared above was arranged parallel on the same substrate to prepare an active matrix mode full-color having a form as described in Fig. 2, and only display section A of said display device is schematically shown in Fig. 3. That is, a wiring section containing plural lines of scanning line 5 and data line 6, and plural pixels 3 (such as a pixel having an emission color of a red region, a pixel of a green region and a pixel of a blue region) arranged parallel are provided on the same substrate, and scanning lines 5 and data lines 6 in a wiring section, which are comprised of a conductive material, respectively, cross each other at a right angle in a grid form to be connected to pixels 3 at the right-angled crossing points (details being not shown in the drawing).

The aforesaid plural pixels 3 each are operated in an active matrix mode, in which an organic EL element, a switching transistor and an operating transistor are provided corresponding to each emission color, and receive an image data signal from data line 6 when a scanning signal is applied from scanning line 5 to emit based on the received image data. Each red, green and blue pixel was appropriately arranged parallel in this manner, whereby a full-color display device was prepared.

It has been proved that a full-color moving image display device exhibiting a high luminance, a high durability and a highly visibility can be achieved by operating said full-color display.

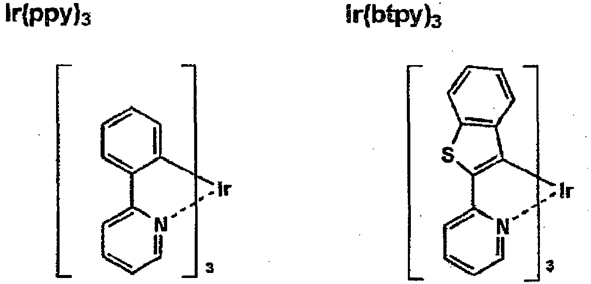

### Example 3 ((Invention having a constitution described in the claims 1 - 7)

### <Preparation of White Emitting Element and White Illumination, which is not part of the present invention>

A transparent electrode substrate of example 1 was subjected to patterning of an electrode having an area of 20 mm x 20 mm, and α-NPD was deposited thereon at a layer thickness of 90 nm as a positive hole injection/transport layer in a similar manner to example 1; and further the aforesaid heating boat charged with H-25, a boat containing Example compound (1-2) and a boat containing Ir(btpy)₃ were supplied with an electric current to deposit an emission layer having a layer thickness of 30 nm, while adjusting the evaporation rates of H-25 as an emission host, phosphorescent compound (1-2) and Ir(btpy)₃ to be 100 : 5 : 0.6.

Successively, BC was deposited at 10 nm to provide a positive hole inhibition layer. Further, Alq₃ was deposited at 40 nm to provide an electron transport layer.

Next, similar to example 1, a mask with square holes having a shape nearly same as a transparent electrode made of stainless steel was arranged on an electron injection layer, and 0.5 nm of lithium fluoride as a cathode buffer layer and 150 nm of aluminum as a cathode were deposited.

This element was equipped with a sealed structure, which had a similar structure of Example 1 and was prepared in a similar method to Example 1, to prepare flat lamp. Nearly white light was obtained when the lamp was supplied with an electric current to prove that said lamp can be utilized as an illumination device.

## Claims

1. An organic electroluminescent element comprising a substrate having thereon electrodes and at least one organic layer,
wherein at least one organic layer is a light-emitting layer incorporating a host compound and a phosphorescent compound, the host compound has a HOMO level of -7.20 to -5.42 eV and a LUMO level of -2.30 to -0.50 eV, and the phosphorescent compound is represented by (II) 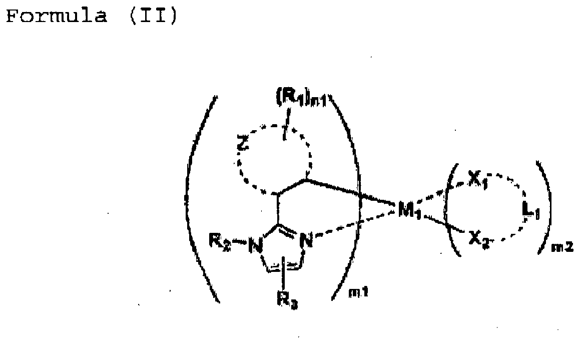 wherein R₁ and R₂ represents a Substituent; R₃ represents a hydrogen atom or a Substituent; Z represents a non-metal atom group necessary to form a 5 to 7-membered ring; n1 represents an integer of 0 to 5; M₁ represents a metal of group 8 to 10 of the periodic table; X₁ and X₂ each independently represent a carbon atom, a nitrogen atom, or an oxygen atom; L₁ represents a group of atoms to form a bidentate Ligand together with X₁ and X₂; m1 is an integer of 1 to 3, and m2 is an integer of 0 to 2, provided that a sum of m1 and m2 is 2 or 3, and
the Substituent represented by R₂ is represented by Formula (III), 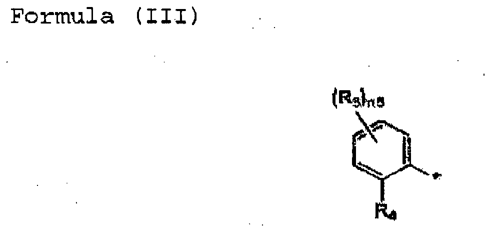 wherein R₄ represents a substituent having a steric parameter value (an Es value) of not more than -0.5, R₅ represents a Substituent, and n5 represent an integer of 0 to 4, an asterisk "*" indicates a bonding position,
wherein values of the HOMO and the LUMO levels denote the value obtained by calculations using Gaussian 98 (Gaussian 98, Revision A. 11. 4, M. J. Frisch, et al., Gaussian, Inc., Pittsburg PA, 2002), which is software for a molecular orbital calculation, and produced by Gaussian Inc., and the value of the HOMO and the LUMO levels of the host compound of the present invention are defined as values (a converted value in eV unit) calculated via structure optimization employing B3LYP/6-31G* as a key word.

2. The organic electroluminescent element of claim 1,
wherein the phosphorescent compound has the HOMO level of -4.80 to -3.50 eV, and the LUMO level of -0.80 to 1.00 eV.

3. The organic electroluminescent element of claims 1 or 2,
wherein m2 is 0 in the phosphorescent compound represented by Formula (II).

4. The organic electroluminescent element of claim 1,
wherein Formula (III) is a mesityl group (a 2, 4, 6-trimethylphenyl group).

5. A display device having the organic electroluminescent element of any one of claims 1 to 4.

6. A lighting device having the organic electroluminescent element of any one of claims 1 to 4.

7. A display device having the lighting device of claim 6 and a liquid crystal element as a display means.

## Patentansprüche

1. Organisches Elektrolumineszenzelement, umfassend ein Substrat mit Elektroden und mindestens einer organischen Schicht darauf,
wobei mindestens eine organische Schicht eine lichtemittierende Schicht ist, in die eine Wirtsverbindung und eine phosphoreszierende Verbindung eingearbeitet ist, die Wirtsverbindung hat ein HOMO-Niveau von -7,20 bis -5.42 eV und ein LUMO-Niveau von -2,30 bis -0,50 eV, und die phosphoreszierende Verbindung ist durch (II) dargestellt 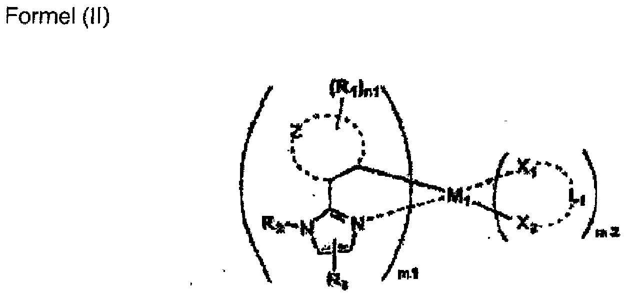 wobei R₁ und R₂ einen Substituenten darstellen; R₃ ein Wasserstoffatom oder einen Substituenten darstellt; Z eine Nichtmetallatomgruppe darstellt, die notwendig ist, um einen 5- bis 7-gliedrigen Ring zu bilden; n1 eine ganze Zahl von 0 bis 5 darstellt; M₁ ein Metall der Gruppe 8 bis 10 des Periodensystems darstellt; X₁ und X₂ jeweils unabhängig ein Kohlenstoffatom, ein Stickstoffatom oder ein Sauerstoffatom darstellen, L2 eine Gruppe von Atomen darstellt, um zusammen mit X₁ und X₂ einen zweizähnigen Liganden zu bilden; m1 eine ganze Zahl von 1 bis 3 ist, und m2 eine ganze Zahl von 0 bis 2 ist, mit der Maßgabe, dass eine Summe von m1 und m2 2 oder 3 ist, und
der durch R2 dargestellte Substituent durch die Formel (III) dargestellt ist 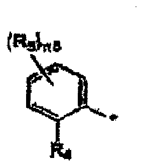 wobei R₄ einen Substituenten mit einem sterischen Parameterwert (Es-Wert) von nicht mehr als -0,5 darstellt, R₅ einen Substituenten darstellt, R₅ einen Substituenten darstellt, und n5 eine ganze Zahl von 0 bis 4 darstellt, ein Stern '*' eine Bindungsposition darstellt,
wobei Werte der HOMO- und LUMO-Niveaus den Wert bezeichnen, der durch Berechnungen unter Verwendung von Gaussian 98 (Gaussian 98, Revision A. 11. 4, M. J. Frisch, und. al., Gaussian, Inc., Pittsburg PA, 2002) erhalten wurde, welches eine Software zum Berechnen von Molekülorbitalen ist und von Gaussian Inc. produziert wird, und der Wert der HOMO- und LUMO-Niveaus der Wirtsverbindung gemäß der vorliegenden Erfindung als Werte (ein in eV-Einheiten umgewandelter Wert) definiert sind, die über Strukturoptimierung unter Verwendung von B3LYP/6-31G* als Schlüsselwort erhalten werden.

2. Organisches Elektrolumineszenzelement nach Anspruch 1, wobei die phosphoreszierende Verbindung das HOMO-Niveau von -4,80 bis -3,50 eV, und das LUMO-Niveau von -0,80 bis 1,00 eV aufweist.

3. Organisches Elektroiumineszenzelement nach Anspruch 1 oder 2,
wobei m2 in der phosphoreszierenden Verbindung, die durch die Formel (II) dargestellt ist, 0 ist.

4. Organisches Elektrolumineszenzelement nach Anspruch 1,
wobei die Formel (III) eine Mesitylgruppe (2,4,6-Trimethylphenylgruppe) ist.

5. Anzeigevorrichtung mit dem organischen Elektrolumineszenzelement nach einem der Ansprüche 1 bis 4.

6. Beleuchtungsvorrichtung mit dem organischen Elektrolumineszenzelement nach einem der Ansprüche 1 bis 4.

7. Anzeigevorrichtung mit der Beleuchtungsvorrichtung nach Anspruch 6 und einem Flüssigkristallelement als Anzeigevorrichtung.

## Revendications

1. Élément électroluminescent organique comprenant un substrat ayant des électrodes et au moins une couche organique là-dessus,
dans lequel au moins une couche organique est une couche émettant de la lumière incorporant un composé hôte et un composé phosphorescent, le composé hôte a un niveau HOMO de -7,20 à -5.42 eV et un niveau LUMO de -2,30 à -0,50 eV, et le composé phosphorescent est représenté par (II) 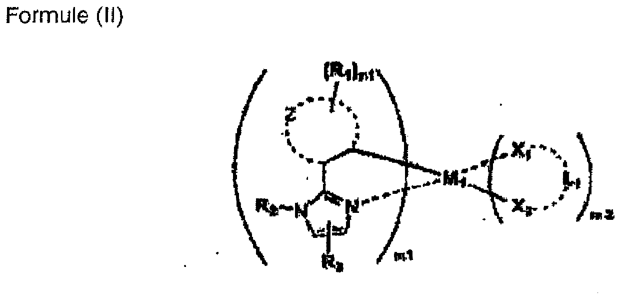 dans laquelle R₁ et R₂ représentent un substituant ; R₃ représente un atome d'hydrogène ou un substituant ; Z représente un groupe d'atome non-métallique nécessaire afin de former un anneau à 5 à 7 membres ; n1 représente un nombre entier de 0 à 5 ; M₁ représente un métal du groupe 8 à 10 du tableau périodique ; X₁ et X₂ chacun indépendamment représente un atome de carbone, un atome d'azote, ou un atome d'oxygène, L₁ représente un groupe d'atomes afin de former un ligand bidenté ensemble avec X₁ et X₂ ; m1 est un nombre entier de 1 à 3, et m2 est un nombre entier de 0 à 2, à condition qu'une somme de m1 1 et m2 est 2 ou 3, et
le substituant représenté par R2 est représenté par la formule (III) Formule (III) 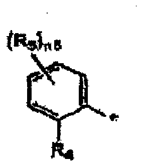 dans laquelle R₄ représente un substituant ayant une valeur de paramètre stérique
(une valeur Es) de ne plus que -0,5, R₅ représente un substituant, et n5 représente un nombre entier de 0 à 4, un astérisque '*' indique une position liante,
dans laquelle des valeurs des niveaux HOMO et LUMO dénotent la valeur obtenue par des calculassions en utilisant Gaussian 98 (Gaussian 98, Revision A. 11. 4, M. J. Frisch, et. al., Gaussian, Inc., Pittsburg PA, 2002), qui est un logiciel de calcul des orbitales moléculaires, et produit par Gaussian Inc., et les valeurs des niveaux HOMO et LUMO du composé hôte selon l'invention présente sont définies en tant que des valeurs (une valeur convertie en des unités eV) calculées par l'intermédiaire d'optimisation structurelle en utilisant B3LYP/6-31G* en tant qu'un mot clé.

2. Élément électroluminescent organique selon la revendication 1, dans lequel le composé phosphorescent a le niveau HOMO de -4,80 à -3,50 eV, et le niveau LUMO de -0,80 à 1,00 eV.

3. Élément électroluminescent organique selon la revendication 1 ou 2,
dans lequel m2 est 0 dans le composé phosphorescent représenté par la formule (II).

4. Élément électroluminescent organique selon la revendication 1,
dans lequel la Formule (III) est un groupe mésityle (un groupe 2,4,6-triméthylphényle).

5. Dispositif d'affichage ayant l'élément électroluminescent organique selon l'une des revendications 1 à 4.

6. Dispositif d'éclairage ayant l'élément électroluminescent organique selon l'une des revendications 1 à 4.

7. Dispositif d'affichage ayant le dispositif d'éclairage selon la revendication 6 et un élément crystal liquide en tant qu'un moyen d'affichage.
